# EUROPÄISCHE PATENTSCHRIFT

(11) **EP 2 203 944 B1**
(45) Veröffentlichungstag und Bekanntmachung des Hinweises auf die Patenterteilung: **16.04.2014**
(21) Anmeldenummer: 08841459.4
(22) Anmeldetag: 24.10.2008
(51) Int. Cl.: C09B 57/00, C08G 61/12, C09B 69/10, H01L 51/00, H01L 51/50

(54) **OPTOELEKTRONISCHE VORRICHTUNG**
OPTOELECTRONIC DEVICE
DISPOSITIF OPTOELECTRONIQUE

(30) Priorität: 24.10.2007 US 923522; 03.09.2008 DE 102008045664
(43) Veröffentlichungstag der Anmeldung: 07.07.2010
(73) Patentinhaber: Merck Patent GmbH, 64293 Darmstadt (DE)
(72) Erfinder: BUCHHOLZ, Herwig, 60599 Frankfurt (DE); HEUN, Susanne, 65812 Bad Soden (DE); LUDEMANN, Aurélie, 60322 Frankfurt (DE); ANEMIAN, Rémi, Manouk, 60316 Frankfurt (DE)
(86) Internationale Anmeldenummer: PCT/EP2008/009021
(87) Internationale Veröffentlichungsnummer: WO 2009/053089

(56) Entgegenhaltungen:
- EP-A- 1 220 341
- EP-A- 1 505 664
- EP-A- 1 647 566
- EP-A- 1 811 533
- WO-A-2005/004251
- US-A1- 2005 037 236

## Beschreibung

Die vorliegende Erfindung betrifft eine optoelektronische Vorrichtung umfassend eine Schicht, enthaltend ein Polymer mit fluorhaltigen Gruppen, wobei zumindest zwischen einem Teil der fluorhaltigen Gruppen der Schicht eine kohäsive Fluor-Fluor-Wechselwirkung besteht. Die Erfindung ist ferner auf die Verwendung der optoelektronischen Vorrichtung sowie auf ein Verfahren zu dessen Herstellung gerichtet.

Elektronische Vorrichtungen, welche organische, metallorganische und/oder polymere Halbleiter enthalten, werden immer häufiger in kommerziellen Produkten verwendet oder stehen kurz vor der Markteinführung. Als Beispiele seien hier Ladungstransportmaterialien auf organischer Basis (beispielsweise Lochtransporter auf Triarylamin-Basis) in Kopiergeräten und organische oder polymere Leuchtdioden (OLEDs oder PLEDs) in Anzeige- und Displayvorrichtungen oder organische Photorezeptoren in Kopierern genannt. Organische Solarzellen (O-SC), organische Feldeffekt-Transistoren (O-FET), organische Dünnfilm-Transistoren (O-TFT), organische Schaltelemente (O-IC), organische optische Verstärker und organische Laserdioden (O-Laser) sind in einem fortgeschrittenen Entwicklungsstand und können in der Zukunft große Bedeutung erlangen.

Viele dieser elektronischen bzw. opto-elektronischen Vorrichtungen weisen unabhängig von dem jeweiligen Verwendungszweck folgenden allgemeinen Schichtaufbau auf, der für die jeweilige Anwendung angepasst werden kann:
(1) Substrat,
(2) Elektrode, die häufig metallisch oder anorganisch, aber auch aus organischen bzw. polymeren leitfähigen Materialien aufgebaut sein kann,
(3) gegebenenfalls eine oder mehrere Ladungsinjektionsschichten bzw. Pufferschichten, beispielsweise zum Ausgleich von Unebenheiten der Elektrode, die häufig aus einem oder mehreren leitfähigen, dotierten Polymer/en ausgebildet ist/sind,
(4) mindestens eine Schicht eines organischen Halbleiters,
(5) gegebenenfalls eine oder mehrere weitere Ladungstransport- bzw. Ladungsinjektions- bzw. Ladungsblockierschicht/en,
(6) Gegenelektrode, bei der die unter (2) genannten Materialien eingesetzt werden,
(7) Verkapselung.

Die vorliegende Erfindung ist insbesondere, aber nicht ausschließlich, auf organische Leuchtdioden (OLED = Organic Light Emitting Diode) gerichtet, die bei Verwendung von polymeren Materialien oft auch als polymere Leuchtdioden (PLEDs) bezeichnet werden. Die obige Anordnung stellt den allgemeinen Aufbau einer optoelektronischen Vorrichtung dar, wobei verschiedene Schichten zusammengefasst werden können, so dass im einfachsten Fall eine Anordnung aus zwei Elektroden, zwischen denen sich eine organische Schicht befindet, besteht. Die organische Schicht erfüllt in diesem Fall alle Funktionen, einschließlich der Emission von Licht. Ein derartiges System ist beispielsweise in der WO 90/13148 A1 auf der Basis von Poly-(p-phenylenen) beschrieben.

Ein Problem, das sich in einem derartigen "Dreischichtsystem" ergibt, ist jedoch die fehlende Steuerung der Ladungstrennung oder die fehlende Möglichkeit, die einzelnen Bestandteile in unterschiedliche Schichten bezüglich ihrer Eigenschaften zu optimieren, wie es beispielsweise bei SMOLEDs ("small-molecule OLEDs") durch einen mehrschichtigen Aufbau einfach gelöst ist. Eine "small molecule OLED" besteht beispielsweise aus einer oder mehreren organischen Lochinjektionsschichten, Lochtransportschichten, Emissionsschichten, Elektronentransportschichten und Elektroneninjektionsschichten sowie einer Anode und einer Kathode, wobei sich das ganze System gewöhnlich auf einem Glassubstrat befindet. Ein Vorteil einer solchen Mehrlagenstruktur besteht darin, dass verschiedene Funktionen der Ladungsinjektion, des Ladungstransports und der Emission in die verschiedenen Schichten aufgeteilt und somit die Eigenschaften der jeweiligen Schichten separat modifiziert werden können.

Typische Lochtransportmaterialien in SMOLEDs sind beispielsweise Di- und Triarylamine, Thiophene, Furane oder Carbazole, wie sie auch in Photoleiteranwendungen untersucht und verwendet werden.

Metallchelate, konjugierte aromatische Kohlenwasserstoffe, Oxadiazole, Imidazole, Triazine, Pyrimidine, Pyrazine, Pyridazine, Phenanthroline, Ketone oder Phosphinoxide werden gewöhnlich für die Emissions- und Elektronentransport-Schichten in SMOLEDs verwendet.

Die Verbindungen, welche in einer SMOLED verwendet werden, können häufig durch Sublimationen gereinigt werden und stehen somit in Reinheiten größer als 99 Prozent zur Verfügung.

Das Aufbringen der Schichten in SMOLED-Vorrichtungen erfolgt gewöhnlich durch Aufdampfen in einer Vakuumkammer. Dieses Verfahren ist jedoch aufwändig und somit teuer und insbesondere für große Moleküle, wie beispielsweise Polymere, ungeeignet.

Polymere OLED-Materialien werden deshalb meist durch Beschichtung aus Lösung aufgetragen. Die Herstellung einer mehrschichtigen organischen Struktur durch Beschichtung aus Lösung erfordert jedoch, dass das Lösungsmittel mit der jeweils vorhergehenden Schicht inkompatibel ist, um diese nicht wieder anzulösen, zu quellen oder gar zu zerstören. Die Wahl des Lösungsmittels erweist sich jedoch als schwierig, da die eingesetzten organischen Verbindungen gewöhnlich ähnliche Eigenschaften, insbesondere ähnliche Lösungseigenschaften, besitzen. Eine Aufbringung weiterer Schichten aus Lösung wird dadurch nahezu unmöglich oder zumindest wesentlich erschwert.

Entsprechend sind polymere OLEDs nach dem Stand der Technik gewöhnlich nur aus einer einschichtigen oder höchstens zweischichtigen organischen Struktur aufgebaut, wobei beispielsweise eine der Schichten für die Lochinjektion und den Lochtransport verwendet wird und die zweite Schicht für die Injektion und den Transport von Elektronen sowie für die Emission verwendet wird.

Insbesondere bei der Herstellung von weißlichtemittierenden PLEDs besteht häufig das Problem, dass es schwierig oder unmöglich ist, ein einzelnes Chromophor zu finden, das Licht im gesamten sichtbaren Bereich emittiert. Deshalb werden im Stand der Technik meist unterschiedliche Chromophore copolymerisiert, wobei es hier allerdings häufig zu Farbverschiebungen oder Quencheffekten kommt.

Eine Möglichkeit diese Problematik des Standes der Technik zu umgehen, ist die Verwendung von Blends, beispielsweise Blends (Mischungen) aus einem blau emittierenden Polymer und einem geringen Anteil einer gelb bis rot emittierenden polymeren oder niedermolekularen Verbindung (z. B. US 6127693). Auch ternäre Blends, in denen dem blau emittierenden Polymer grün und rot emittierende Polymere oder niedermolekulare Verbindungen zugemischt sind, sind in der Literatur bekannt (z. B. Y. C. Kim et al., Polymeric Materials Science and Engineering 2002, 87, 286; T.-W. Lee et al., Synth. Metals 2001, 122, 437). Eine Zusammenfassung über solche Blends gibt S.-A. Chen et al., ACS Symposium Series 1999, 735 (Semiconducting Polymers), 163. Diese Blends, unabhängig davon, ob es sich um Blends mit Polymeren oder niedermolekularen Verbindungen handelt, haben zwei entscheidende Nachteile: Die Polymere in Blends sind oft nicht ideal miteinander mischbar und neigen dadurch zu deutlich schlechterer Filmbildung oder Phasentrennung im Film. Die Bildung homogener Filme, wie sie für die Verwendung in Leuchtdioden essentiell sind, ist häufig nicht möglich. Auch eine Phasentrennung in der Vorrichtung bei längerem Betrieb wird beobachtet und führt zur Verringerung der Lebensdauer und zu Farbinstabilitäten. Auch hier sind Blends im Nachteil, da die einzelnen Blendkomponenten unterschiedlich schnell altern und damit zu einer Farbverschiebung führen. Deshalb sind Blends im Vergleich zu Copolymeren weniger geeignet für die Verwendung in PLEDs.

Weißlichtemittierende PLEDs wären insbesondere vorteilhaft, um vollfarbige Displays herzustellen und dabei aufwändige Drucktechniken zu vereinfachen oder zu umgehen. Dazu könnte man ein weiß emittierendes Polymer entweder großflächig oder strukturiert auftragen und die einzelnen Farben daraus durch einen Farbfilter erzeugen, wie es bereits bei Flüssigkristallanzeigen (LCD) Stand der Technik ist. Weiß emittierende Polymere können weiterhin Verwendung finden für monochrom weiße Displays. Des Weiteren ist die Verwendung weiß emittierender Polymere in Flüssigkristallanzeigen als Backlight möglich, sowohl für monochrome wie auch für mehrfarbige Displays. In der breitest möglichen Anwendung ist die weiße Emission für allgemeine Beleuchtungszwecke (Illumination) einzusetzen, da Weiß dem Sonnenlicht am ähnlichsten ist.

Aus dem oben beschriebenen Stand der Technik ist offensichtlich, dass weißlichtemittierende PLEDs sinnvoll wären, es jedoch bislang noch keine Lösung gibt, wie hochwertige, weiß emittierende PLEDs erhalten werden können.

Vorteilhaft bei den polymeren OLEDs wäre offensichtlich auch eine Mehrschichtstruktur wie bei den SMOLEDs, wobei im Stand der Technik verschiedene Ansätze versucht wurden.

So offenbart beispielsweise die EP 0 637 899 A1 eine elektrolumineszierende Anordnung, enthaltend eine oder mehrere organische Schichten, wobei eine oder mehrere der Schichten durch thermische oder strahlungsindizierte Vernetzung erhalten werden. Ein Problem bei der thermischen Vernetzung ist, dass die polymeren Schichten einer relativ hohen Temperatur ausgesetzt werden, was zum Teil wieder zur Zerstörung der entsprechenden Schicht oder zur Bildung unerwünschter Nebenprodukte führt. Bei der Vernetzung mit aktinischer Strahlung sind häufig Moleküle oder Molekülteile notwendig, die eine radikalische, kationische oder anionische Polymerisation auslösen können. Es ist im Stand der Technik jedoch bekannt, dass solche Moleküle oder Molekülteile negative Einflüsse auf die Funktion einer optoelektronischen Vorrichtung haben können. Auch ist die Verwendung der energiereichen aktinischen Strahlung problematisch.

Ebenso bevorzugt ist, dass die Schicht ein Polymer mit Emitterfunktion umfasst. Weiterhin bevorzugt ist, wenn die Schicht ein Polymere mit Lochinjektions- und/oder Lochtransportfunktion und/oder Emitterfunktion umfasst.

In einer weiteren Ausführungsform der Erfindung ist es bevorzugt, dass das Polymer ein Blend aus zwei oder mehr Polymeren ist. Besonders bevorzugt weist zumindest eines der Polymere, ganz besonders bevorzugt alle Polymere, fluorhaltige Gruppen auf.

Die erfindungsgemäße Vorrichtung umfasst ferner wenigstens eine weitere Schicht.

Im Sinne dieser Erfindung ist ebenfalls bevorzugt, dass die weitere Schicht ein Polymer mit Lochinjektionsfunktion, Lochtransportfunktion,

EP-A-1 220 341 und EP-A-1 647 566 offenbaren optoelektronische Vorrichtungen umfassend mindestens eine Schicht, enthaltend ein Polymer mit fluorhaltigen Gruppen.

Die Aufgabe der vorliegenden Erfindung bestand somit in der Bereitstellung einer optoelektronischen Vorrichtung, bei der eine polymere Schicht ohne Anwendung energiereicher Strahlung fixiert ist.

Die Aufgabe wird gelöst durch eine optoelektronische Vorrichtung umfassend mindestens eine Schicht, die dadurch gekennzeichnet ist, dass diese mindestens eine Schicht ein Polymer mit 1 bis 50% Wiederholungseinheiten, bezogen auf die Wiederholungseinheiten des Polymers, mit fluorhaltigen Gruppen sowie weiteren Str ktureinheiten ausgewählt aus:
a) Fluoren-, Indenoffuoren-, Spirobifluoren-, Phenanthre - und Dihydrophenanthren-Derivaten,
b) substituierten oder unsubstituierten Triarylaminen, Benzidinen, Tetraarylen-para-phenylendiaminen, Phenothiazinen, Phenoxazinen, Dihydrophenazinen, Thianthrenen, Dibenzo-*p*-dioxinen, Phenoxathiinen, Carbazolen, Azulenen, Thiophenen, Pyrrolen und Furanen, und/oder c) substituierten oder unsubstituierten Pyridinen, Pyrimidinen, Pyridazinen, Pyrazinen, Pyrenen, Perylenen, Anthracenen, Benzanthracenen, Oxadiazolen, Chinolinen, Chinoxalinen, Phenazinen, Benzimidazolen, Ketonen, Phosphinoxiden, Sulfoxiden und Triazinen, enthält wobei zumindest zwischen einem Teil der fluorhaltigen Gruppen der Schicht eine kohäsive Fluor-Fluor-Wechselwirkung besteht.

Diese Wechselwirkung sorgt für eine Art physikalische Vernetzung der Schicht, indem sich die fluorierten Gruppen zweier oder mehrerer Polymerstränge aneinander anlagern und so zu einer "Molekulargewichtserhöhung" (intermolekulare Dimere, Trimere, etc.) führen, ohne dass eine chemische Reaktion stattfinden muss. Da die Löslichkeit einer Schicht vom Vernetzungsgrad und effektiven Molekulargewicht abhängt, verursacht die kohäsive Wechselwirkung die Unlöslichkeit der Schicht selbst in dem Lösungsmittel, aus dem sie ursprünglich abgeschieden wurde. Auf diese Art und Weise können daher auch mehrere Schichten aus einem Lösungsmittel abgeschieden werden, ohne dass sich die zuvor abgeschiedenen Schichten wider lösen.

In einer bevorzugten Ausführungsform der Erfindung umfasst die Schicht ein Polymer mit Ladungsinjektions- und/oder Ladungstransportfunktion.

Lochblockierfunktion, Emitterfunktion, Elektroneninjektionsfunktion, Elektronenblockierfunktion und/oder Elektronentransportfunktion umfasst.

Die weitere Schicht kann ein weiteres Polymer mit fluorhaltigen Gruppen enthalten. Dies ist immer dann bevorzugt, wenn weitere Schichten abgeschieden werden sollen. Anstelle des Polymers der weiteren Schicht kann auch ein fluoriertes Oligomer oder ein fluoriertes kleines Molekül eingesetzt werden. Unter einem Oligomer im Sinne dieser Erfindung wird ein Molekül verstanden, dass mehr als 2 Wiederholungseinheiten, bevorzugt 3 bis 9, aufweist. Ein Polymer weist bevorzugt 10 oder mehr Wiederholungseinheiten auf.

In einer weiteren bevorzugten Ausführungsform der Erfindung ist es bevorzugt, dass das Polymer der weiteren Schicht mindestens eine Emitterfunktion aufweist. Insbesondere soll das Polymer mit Emitterfunktion Licht verschiedener Wellenlängen emittieren. Dies kann dadurch erreicht werden, dass in der Schicht unterschiedliche Emitter in einem oder in mehreren Polymeren oder einem Blend vorliegen.

Darüber hinaus ist es bevorzugt, dass die Vorrichtung mehrere Schichten von Polymeren mit Emitterfunktion umfasst. Besonders bevorzugt ist dabei, dass die mehreren Schichten der Polymere mit Emitterfunktion jeweils Licht verschiedener Wellenlängen emittieren.

In einer besonders bevorzugten Ausführungsform ist es ferner bevorzugt, dass sich die verschiedenen Wellenlängen zur Farbe Weiß addieren.

Eine bevorzugte Ausführungsform der Erfindung umfasst beispielsweise eine Mehrschichtanordnung für einen Weißlichtemitter, umfassend eine Zwischenschicht und beispielsweise drei Schichten für die Emission der drei Grundfarben Rot, Grün und Blau (RGB). Diese können in der für die Ladungs- und Farb-balance geeigneten Reihenfolge und Schichtdicke abgeschieden werden, wobei die zunächst abgeschiedenen Schichten durch die kohäsive Kraft der Fluor-Fluor-Wechselwirkung unlöslich gemacht werden. Dabei können Singulett und hocheffiziente Triplettemitter durch die Verteilung auf mehrere Schichten kombiniert werden, was in einer Schicht nicht möglich ist.

Eine weitere bevorzugte Ausführungsform enthält eine blaue Polymerschicht, die über F-F-Wechselwirkungen unlöslich gemacht wurde und mit einer Schicht, enthaltend einen gelben Triplett-Emitter, übercoatet wurde. Der gelbe Triplett-Emitter kann ein echter gelber Emitter sein oder ein Emitter, welcher sich aus einem roten und grünen Emitter zusammensetzt. Durch den Einsatz von stabilen Triplett-Emittern mit hohen Effizienzen kann ein Weißlicht emittierendes System mit hoher Effizienz und hoher Lebensdauer erhalten werden. Dieses System zeichnet sich zudem durch eine einfache Herstellungsmethode (keine Vakuumaufdampfung erforderlich) und somit geringere Kosten aus.

In einer noch weiteren Ausführungsform der Erfindung kann die Vorrichtung mehrere Schichten von Polymeren mit Lochleiterfunktion umfassen, wobei die Lochleiter energetisch unterschiedliche höchste besetzte Molekülorbitale (HOMO) aufweisen.

Dabei ist es insbesondere bevorzugt, dass die zuletzt aufgebrachte Polymerschicht mit Lochleiterfunktion ein energetisch hohes niedrigstes unbesetztes Molekülorbital (LUMO) aufweist. Auf diese Weise ist die zuletzt aufgebrachte Polymerschicht eine Elektronenblockierschicht.

In einer noch weiteren Ausführungsform der Erfindung kann die Vorrichtung mehrere Schichten von Polymeren mit Elektronenleiterfunktion umfassen, wobei die Elektronenleiter energetisch niedrigste unbesetzte Molekülorbitale (LUMO) aufweisen.

Dabei ist es insbesondere bevorzugt, dass die zuerst aufgebrachte Polymerschicht mit Elektronenleiterfunktion ein energetisch niedriges höchstes besetztes Molekülorbital (HOMO) aufweist. Auf diese Weise ist die zuerst aufgebrachte Polymerschicht eine Lochblockierschicht.

Eine bevorzugte Ausführungsform umfasst somit eine Mehrschichtanordnung, umfassend mehrere (teil-)fluorierte polymere Lochleiter und/oder Elektronenleiter (Interlayer) mit unterschiedlichem HOMO ("highest occupied molecular orbital") und entsprechend Elektronen-bzw. Lochblockierfunktion. Dadurch kann eine verbessere Loch- bzw Elektroneninjektion aufgrund von abgestuften Barrierestufen erreicht werden.

Erfindungsgemäß kann es ferner von Vorteil sein, dass die Vorrichtung eine Schicht (oder mehrere Schichten) mit kleinen Molekülen oder Oligomeren umfasst. Diese wird bevorzugt als letzte Schicht (vor einer Kathode) aufgebracht. Die Aufbringung der Schicht kann durch Beschichten aus Lösung, durch Druckverfahren durch Aufdampfen oder sonstige im Stand der Technik bekannte Methoden erfolgen.

"Ein Teil" derfluorhaltigen Gruppen bedeutet dabei, dass etwa 1 bis 100 %, bevorzugt 40 bis 100 % und besonders bevorzugt 80 % bis 100% der fluorhaltigen Gruppen in Wechselwirkung treten. Dabei sollten die fluorhaltigen Gruppen innerhalb der Schicht in einem möglichst großen Anteil miteinander wechselwirken, um den Vernetzungscharakter der Schicht zu verstärken. Dabei sollte der Abstand der Fluoratome, um miteinander in Wechselwirkung zu treten, in etwa dem Van-der-Waals Radius entsprechen. Zumindest ist der Abstand der Fluoratome zueinander so, dass eine attraktive F-F-Wechselwirkung eintritt, vergleichbar mit der Wechselwirkung bei Wasserstoffbrückenbindungen. Erfindungsgemäß umfasst ein Polymer in einer erfindunsgemäßen Schicht 1 bis 50% und vorzugsweise 1 bis 25% fluorhaltige Gruppen, bezogen auf die Wiederholungseinheiten des Polymers.

Die erfindungsgemäße Vorrichtung umfasst ferner eine Elektrode (Anode), wobei die Elektrode (Anode) bevorzugt eine Indium-Zinnoxid-Schicht (ITO) bzw. eine Indium-Zinkoxid-Schicht (IZO) oder ein leitfähiges Polymer ist oder eine Kombination von beidem ist. Das leitfähige Polymer ist bevorzugt ausgewählt aus PEDOT oder PANI. Weitere bevorzugte (intrinsisch) leitfähige Polymere sind, Polythiophen (PTh), Poly(3,4-ethylenedioxythiophene) (PEDT), Polydiacetylen, Polyacetylen (PAC), Polypyrrol (PPy), Polyisothianaphthen (PITN), Polyheteroarylenvinylen (PArV), wobei die Heteroarylen-Gruppe z.B. Thiophen, Furan oder Pyrrol sein kann, Poly-p-phenylen (PpP), Polyphenylensulfid (PPS), Polyperinaphthalin (PPN), Polyphthalocyanin (PPc) u.a., sowie deren Derivate (die z.B. aus mit Seitenketten oder -gruppen substituierten Monomeren gebildet werden), deren Copolymere und deren physikalische Mischungen.

Die erfindungsgemäße optoelektronische Vorrichtung umfasst darüber hinaus bevorzugt eine Kathode und vorteilhaft auch eine Verkapselung.

Die erfindungsgemäße optoelektronische Vorrichtung kann als organische oder polymere Leuchtdiode, als organische Solarzelle, als organischer Feldeffekt-Transistor, als organisches Schaltelement, als organisches Feld-Quench-Element, als organischer optischer Verstärker, als organische Laserdiode, als organischer Photorezeptor und als organische Photodiode verwendet werden.

Die erfindungsgemäße optoelektronische Vorrichtung kann als OLED in einem Display, in einem farbigen, mehrfarbigen oder vollfarbigen Display, als Beleuchtungselement oder als Backlight in einem Flüssigkristall-Display (LCD) verwendet werden. Bevorzugt kann die optoelektronische Vorrichtung als Weißlicht emittierende OLED verwendet werden.

Die erfindungsgemäße optoelektronische Vorrichtung kann in einem weiß emittierenden Display verwendet werden.

Die erfindungsgemäße optoelektronische Vorrichtung kann in einem farbigen, mehrfarbigen oder vollfarbigen Display verwendet werden, wobei die Farbe durch Verwendung eines Farbfilters auf einer weiß emittierenden PLED erzeugt wird.

Die erfindungsgemäße optoelektronische Vorrichtung kann als Beleuchtungselement verwendet werden.

Die erfindungsgemäße optoelektronische Vorrichtung kann in einem Flüssigkristall-Display (LCD), enthaltend als Backlight eine weiß emittierende PLED, verwendet werden.

Im Sinne dieser Erfindung besitzen die fluorhaltigen Gruppen R_{f} bevorzugt die allgemeine Formel CₓH_{y}F_{z}, wobei x ≥ 0, y ≥ 0 und z ≥ 1 sind und keine, eine oder mehrere CH₂-Gruppen, die auch benachbart sein können, durch O, S, Se, Te, Si(R¹)₂, Ge(R¹)₂, NR¹, PR¹, CO, P(R¹)O ersetzt sein können, wobei R¹ bei jedem Auftreten gleich oder verschieden eine geradkettige, verzweigte oder cyclische Alkyl-, Alkenyl-, Alkinyl-, Aryl-, Arylalkyl-, Arylalkenyl-, Arylalkinyl-, Heteroaryl- oder Heteroalkylgruppe ist, wobei auch ein oder mehrere nicht benachbarte C-Atome der nicht aromatischen Anteile durch O, S, CO, COO oder OCO ersetzt sein können, mit der Maßgabe, dass zwei Reste R¹ auch miteinander Ringsysteme bilden können. Bevorzugte Gruppen umfassen beispielsweise F, CF₃, C₂F₅, CF₃(CH₂)ₐS, CF₃CF₂S oder (CF₃-(CH₂)ₐ)₂N, wobei a bevorzugt eine ganze Zahl von 0 bis 5 darstellt.

Überraschenderweise konnte gefunden werden, dass nach dem Aufbringen eines fluorierten Polymers oder eines Polymers mit fluorierten oder perfluorierten Seitengruppen aus Lösung nach dem Entfernen des Lösungsmittels das Polymer sich nicht mehr lösen oder abwaschen lässt und auch nicht quillt. Die Schicht konnte also ohne Anwendung von hohen Temperaturen und ohne Anwendung energiereicher Strahlung fixiert werden. Somit kann problemlos eine weitere Schicht aus Lösung aufgebracht werden ohne die Struktur der vorhergehenden Schicht zu schädigen. Überraschenderweise wurde zudem gefunden, dass bei Aufbringung mehrerer fluorierter Polymere (oder fluorierter Oligomere oder fluorierter kleiner Moleküle) durch die Fluor-Fluor-Wechselwirkung der Schichten eine Adhäsion untereinander verursacht wird. Die einzelnen Schichten werden durch Aufbringung weiterer Schichten aus Lösung nicht wieder angelöst und quellen auch nicht. Auf diese Weise können polymere, mehrschichtige Vorrichtungen bereitgestellt werden, wie sie von den "small molecule OLEDs" bekannt sind.

Die erste Schicht befindet sich vorzugsweise auf einem Substrat, auf welchem sich gewöhnlich eine Elektrode befindet. Bevorzugte Materialien für das Substrat sind z. B. Gläser und Folien, die eine ausreichende mechanische Stabilität und eine Barrierewirkung gewährleisten. Das Substrat kann beispielsweise elektrisch leitfähig beschichtet sein oder es kann eine Indium-Zinnoxid (ITO) oder Indium-Zinkoxid (IZO) aufgebracht sein, was gewöhnlich durch Sputtern geschieht.

Ebenso kann ein leitfähiges Polymer auf das Substrat aufgebracht sein, beispielsweise durch Beschichtung aus Lösung, und als Elektrode dienen. Das leitfähige Polymer ist vorzugsweise ausgewählt aus PEDOT und PANI. Es kann durch fluorierte Gruppen modifiziert sein. Bevorzugt ist das Polymer dotiert und kann somit als Ladungsinjektionsschicht fungieren. Bevorzugt ist das Polymer ein Polythiophenderivat, besonders bevorzugt Poly(3,4-ethylendioxy-2,5-thiophen) (PEDOT) oder Polyanilin (PANI). Bevorzugt werden die Polymere mit Polystyrolsulfonsäure oder anderen Polymer gebundenen Brönsted-Säuren dotiert und so in einen leitfähigen Zustand gebracht.

Es ist ferner bevorzugt, dass die erste Schicht eine Lochinjektionsfunktion und/oder eine Lochtransportfunktion umfasst. Beide Funktionen können beispielsweise durch dotierte Polythiophenderivate oder Polyaniline bereitgestellt werden.

Ebenso bevorzugt im Sinne dieser Erfindung kann die erste Schicht eine Emitterfunktion umfassen. Dies kann beispielsweise durch Copolymerisation von Emitterverbindungen oder photolumineszierenden Verbindungen mit den Monomeren des entsprechenden Polymers erfolgen. Die Emitterverbindungen oder photolumineszierenden oder elektrolumineszierenden Verbindungen können sich in der Hauptkette oder der Seitenkette des Polymers befinden oder können beispielsweise an geeigneten Stellen aufgepfropft werden. Ebenso können monomere oder polymere Emitterverbindungen eingesetzt werden, welche ebenfalls fluorhaltige Gruppen aufweisen können.

Vorzugsweise umfasst die erfindungsgemäße optoelektronische Vorrichtung eine zweite Schicht. Ebenso bevorzugt ist, dass neben der zweiten Schicht noch weitere zusätzliche Schichten in der Vorrichtung vorhanden sind. Im Sinne dieser Erfindung ist es bevorzugt, dass die zusätzliche Schicht (oder die zusätzlichen Schichten) Verbindungen mit fluorhaltigen Gruppen, vorzugsweise wie oben definiert, umfassen. Somit kann auch die zusätzliche Schicht ein teilweise fluoriertes Polymer oder ein Polymer mit fluorierten oder perfluorierten Seitengruppen, aber auch ein Oligomer mit fluorierten Gruppen oder ein fluoriertes Molekül (kleines Molekül) sein.

Erfindungsgemäß zeichnet sich die optoelektronische Vorrichtung dadurch aus, dass sich ein Teil der fluorhaltigen Gruppen der zusätzlichen Schicht und der jeweiligen vorhergehenden Schicht in so einem Abstand voneinander befinden, dass eine adhäsive Fluor-Fluor-Wechselwirkung besteht. Im Sinne dieser Erfindung kann die zusätzliche Schicht eine Ladungsinjektionsschicht (Loch- oder Elektroneninjektionsschicht), eine Ladungstransportschicht (Loch- oder Elektronentransportschicht), eine Emitterschicht, eine Loch- oder Elektronenblockierschicht und/oder eine Kombination der genannten sein. Das heißt wiederum, dass die zusätzliche Schicht mehrere Funktionen in einer Schicht vereinen kann, bzw. dass mehrere zusätzliche Schichten die entsprechenden Funktionen übernehmen.

Dadurch ist erfindungsgemäß ein klassischer Aufbau aus Substrat, Elektrode, Multifunktionsschicht und Kathode oder ein Aufbau wie bei einem "small molecule OLED" möglich, nämlich ein Aufbau aus
1) Substrat,
2) Elektrode bzw. Anode,
3) Lochinjektionsschicht/en,
4) Lochtransportschicht/en,
5) Emissionsschicht/en
6) Elektronentransportschicht/en
7) Elektroneninjektionsschicht/en und
8) Gegenelektrode bzw. Kathode.

Erfindungsgemäß können eine oder mehrere der Schichten miteinander kombiniert werden oder es kann der Aufbau aus polymeren Schichten mit Schichten, wie sie aus einem SMOLED bekannt sind, kombiniert werden. Beispielsweise können Komponenten aufgedampft oder aufgedruckt werden, falls dies gewünscht ist, oder es können Komponenten aus Lösung aufgebracht werden, wobei die Komponenten bevorzugt fluorhaltige Gruppen aufweisen.

Auf diese Weise können Vorrichtungen mit dickeren Schichten bereitgestellt werden, wobei diese Schichten beispielsweise als Lochinjektionsschichten oder Elektronen-Sperrschichten fungieren können. Derartige Schichten können einfach bezüglich deren Farbe und Effektivität optimiert werden. Darüber hinaus ist die Lebensdauer einer derartigen Schicht durch eine verbesserte Elektronensperrfunktion erhöht (weniger Tunneleffekte in die darunter liegende Schicht, insbesondere bei PEDOT der Fall).

Die optoelektronische Vorrichtung im Sinne der vorliegenden Erfindung eignet sich als organische oder polymere Leuchtdiode, als organische Solarzelle (O-SC, z. B. WO 98/48433, WO 94/05045), als organischer Feldeffekt-Transistor (O-FETs), als organisches Schaltelement (O-IC, z. B. WO 95/31833, WO 99/10939), als organisches Feld-Ouench-Element (FDQ, z. B. US 2004/017148), als organischer optischer Verstärker, als organischer Photorezeptor, als organische Photodiode oder als organische Laserdiode (O-LASER, z. B. WO 98/03566) und kann entsprechend dazu verwendet werden.

Für die Verwendung in O-FETs sind vor allem Materialien mit hoher Ladungsträgermobilität von Interesse. Dies sind beispielsweise Oligo- oder Poly(triarylamine), Oligo- oder Poly(thiophene) und Copolymere, die einen hohen Anteil dieser Einheiten enthalten.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt. Dabei kann es auch bevorzugt sein, als Elektrodenmaterial für eine oder beide der Elektroden ein leitfähiges, dotiertes Polymer zu verwenden und keine Zwischenschicht aus leitfähigem, dotiertem Polymer einzubringen.

Für Anwendungen in O-FETs und O-TFTs ist es außerdem erforderlich, dass der Aufbau außer Elektrode und Gegenelektrode (source und drain) noch eine weitere Elektrode (gate) enthält, die durch eine Isolatorschicht mit einer in der Regel hohen (oder selten niedrigen) Dielektrizitätskonstante vom organischen Halbleiter abgetrennt ist. Außerdem kann es sinnvoll sein, in die Vorrichtung noch weitere Schichten einzubringen.

Die Elektroden werden im Sinne dieser Erfindung so gewählt, dass ihr Potential möglichst gut mit dem Potential der angrenzenden organischen Schicht übereinstimmt, um eine möglichst effiziente Elektronen- bzw. Lochinjektion zu gewährleisten.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide in Frage (z. B. LiF, Li₂O, BaF₂, MgO, NaF, etc.). Die Schichtdicke dieser Schicht beträgt bevorzugt zwischen 1 und 10 nm.

Als Anode sind Materialien mit hoher Austrittsarbeit bevorzugt. Bevorzugt weist die Anode ein Potential größer 4,5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink-Oxid (IZO), welche fluorhaltige Gruppen aufweisen. Bevorzugt sind weiterhin leitfähige, dotierte organische Materialien, insbesondere leitfähige dotierte Polymere, welche bevorzugt fluorhaltige Gruppen, wie oben definiert, aufweisen.

Als Lochinjektionsschicht auf der Anode kommen verschiedene dotierte, leitfähige Polymere in Frage. Bevorzugt sind Polymere, die je nach Anwendung eine Leitfähigkeit > 10⁻⁸ S/cm aufweisen. Das Potential der Schicht beträgt bevorzugt 4 bis 6 eV vs. Vakuum. Die Schichtdicke beträgt bevorzugt zwischen 10 und 500 nm, besonders bevorzugt zwischen 20 und 250 nm. Besonders bevorzugt werden Derivate von Polythiophen (insbesondere Poly(3,4-ethylendioxy-2,5-thiophen) (PEDOT) und Polyanilin (PANI) verwendet. Weitere bevorzugte (intrinsisch) leitfähige Polymere sind, Polythiophen (PTh), Poly(3,4-ethylendioxythiophen) (PEDOT), Polydiacetylen, Polyacetylen (PAc), Polypyrrol (PPy), Polyisothianaphthen (PITN), Polyheteroarylenvinylen (PArV), wobei die Heteroarylen-Gruppe z.B. Thiophen, Furan oder Pyrrol sein kann, Poly-p-phenylen (PpP), Polyphenylensulfid (PPS), Polyperinaphthalin (PPN), Polyphthalocyanin (PPc) u.a., sowie deren Derivate (die z.B. aus mit Seitenketten oder -gruppen substituierten Monomeren gebildet werden), deren Copolymere und deren physikalische Mischungen. Die Dotierung erfolgt in der Regel durch Säuren oder durch Oxidationsmittel. Bevorzugt erfolgt die Dotierung durch Polymer gebundene Brönsted-Säuren. Besonders bevorzugt sind hierfür Polymer gebundene Sulfonsäuren, insbesondere Poly(styrolsulfonsäure) und Poly(vinylsulfonsäure). Vorzugsweise weist das leitfähige Polymer für die Ladungsinjektionsschicht fluorhaltige Gruppen auf, wodurch nach dem Aufbringen aus Lösung und Entfernen des Lösungsmittels eine Fixierung der Schicht durch kohäsive F-F-Wechselwirkungen erfolgt.

Bevorzugt enthält das Polymer der Emitterschicht neben emittierenden Wiederholungseinheiten weitere Wiederholungseinheiten, die ebenfalls bevorzugt fluorhaltige Gruppen bzw. Substituenten aufweisen. Es kann sich dabei um eine einzige polymere Verbindung oder um einen Blend aus zwei oder mehr polymeren Verbindungen oder um einen Blend aus einer oder mehrerer polymerer Verbindungen mit einer oder mehreren niedermolekularen organischen Verbindungen handeln. Die organische Emitterschicht kann bevorzugt durch Beschichtung aus Lösung oder durch verschiedene Druckverfahren, insbesondere durch Tintenstrahldruckverfahren aufgebracht werden. Die polymere Verbindung und/oder die weiteren Verbindungen weisen bevorzugt fluorhaltige Gruppen auf. Die Schichtdicke des organischen Halbleiters beträgt je nach Anwendung bevorzugt 10 bis 500 nm, besonders bevorzugt 20 bis 250 nm.

Bevorzugte Wiederholungseinheiten im Polymer der Emitterschicht sind, ohne darauf beschränkt zu sein, beispielsweise die im Folgenden gezeigten Verbindungen:

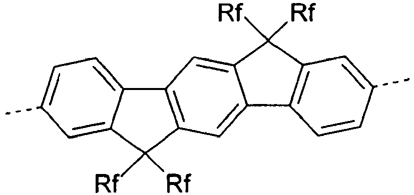

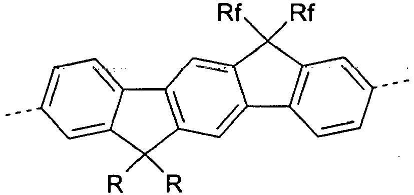

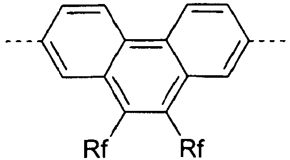

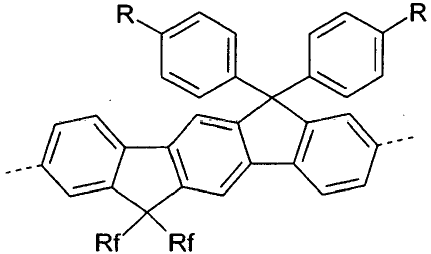

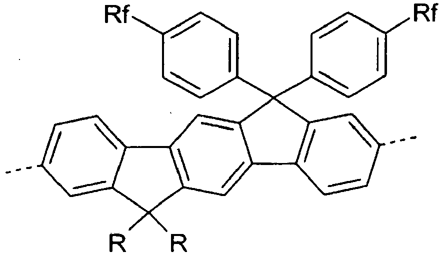

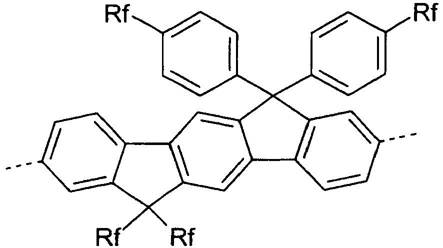

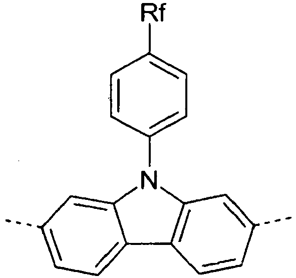

Dabei bedeutet Rf einen fluorierten Rest der allgemeinen Formel CₓH_{y}F_{z}, wobei x ≥ 0, y ≥ 0 und z ≥ 1 sind und keine, eine oder mehrere CH₂-Gruppen, die auch benachbart sein können, durch O, S, Se, Te, Si(R¹)₂, Ge(R¹)₂, NR¹, PR¹, CO, P(R¹)O ersetzt sein können, wobei R¹ sowie R bei jedem Auftreten gleich oder verschieden eine geradkettige, verzweigte oder cyclische Alkyl-, Alkenyl-, Alkinyl-, Aryl-, Arylalkyl-, rylalkenyl-, Aryialkinyl-, Heteroaryl- oder Heteroalkylgruppe ist, wobei auch ein oder mehrere nicht benachbarte C-Atome der nicht arometischen Anteile durch O, S, CO, COO oder OCO ersetzt sein können, mit der Maßgabe, dass zwei Reste R¹ auch miteinander Ringsysteme bilden köpfen Bevorzugte Gruppen umfassen beispielsweise F, CF₃, C₂F₅, CF₃(CH₂)ₐS, CF₃CF₂S oder (CF₃-(CH₂)ₐ)₂N, wobei a bevorzugt eine ganze Zahl von 0 bis 5 darstellt.

Bevorzugte Polymere bzw. fluorhaltige Polymere (oder Polymere mit fluorierten oder perfluorierten Seitengruppen) im Sinne dieser Erfindung sind konjugierte Polymere oder teilkonjugierte Polymere die in der Hauptkette sp²-hybridisierte Kohlenstoffatome enthalten, die auch durch entsprechende Heteroatome ersetzt sein können. Des Weiteren wird im Sinne dieser Erfindung ebenfalls als konjugiert bezeichnet, wenn sich in der Hauptkette beispielsweise Arylamineinheiten und/oder bestimmte Heterocyclen (d. h. Konjugation über N-, O- oder S-Atome) und/oder metallorganische Komplexe (d. h. Konjugation über das Metallatom) befinden. Typische Vertreter konjugierter Polymere, wie sie beispielsweise in PLEDs oder O-SCs verwendet werden können, sind oly-paraphenylenvinylene (PPV), Polyfluorene, Polyspirobifluorene, Polyphenanthrene, Polydihydrophenanthrene, Polyindenofluorene, Systeme, die im weitesten Sinne auf Poly-p-phenylenen (PPP) basieren, und Derivate dieser Strukturen, insbesondere solche Derivate, die fluorhaltige Gruppen aufweisen.

Erfindungsgemäß sind Polymere, die weitere Strukturelemente enthalten und somit als Copolymere zu bezeichnen sind. Hier sei vor allem auch auf die relativ umfangreichen Auflistungen von möglichen Strukturelementen in der WO 02/077060, der WO 2005/014689 und die in diesen Schriften aufgeführten Zitate verwiesen. Diese weiteren Struktureinheiten werden dabei aus den im Folgenden beschriebenen Gruppen 1, 2 und/oder 3 sowie gegebenenfalls zusätzlich aus den Gruppen 4, 5, 6 und 7 ausgewählt.
- Gruppe 1:: Struktureinheiten, welche das Polymer-Grundgerüst darstellen.
- Gruppe 2:: Struktureinheiten, welche die Lochinjektions- und/oder -transporteigenschaften der Polymere erhöhen.
- Gruppe 3:: Struktureinheiten, welche die Elektroneninjektions- und/oder -transporteigenschaften der Polymere erhöhen.
- Gruppe 4:: Struktureinheiten, die Kombinationen von Einzeleinheiten der Gruppe 2 und Gruppe 3 aufweisen.
- Gruppe 5:: Struktureinheiten, welche die Morphologie und/oder die Emissionsfarbe der resultierenden Polymere beeinflussen.
- Gruppe 6:: Struktureinheiten, welche die Emissionscharakteristik insoweit verändern, dass Elektrophosphoreszenz statt Elektrofluoreszenz erhalten werden kann.
- Gruppe 7:: Struktureinheiten, welche den Übergang vom Singulett- zum Triplettzustand verbessern.

Geeignete und bevorzugte Einheiten für die oben genannten Gruppen werden im Folgenden beschrieben, wobei diese bevorzugt die erfindungsgemäß definierten fluorhaltigen Gruppen aufweisen.

### Gruppe 1 - Struktureinheiten, welche das Polymer-Grundgerüst darstellen:

Geeignete Einheiten sind Fluoren-Derivate, wie z.B. in der EP 0842208, der WO 99/54385, der WO 00/22027, der WO 00/22026 und der WO 00/46321 offenbart, Indenofluorene, ferner Spirobifluoren-Derivate, wie z.B. in der EP 0707020, der EP 0894107 und der WO 03/020790 offenbart, Phenanthren-Derivate oder Dihydrophenanthren-Derivate, wie z.B. in der

WO 2005/014689 offenbart. Es ist auch möglich, eine Kombination von zwei oder mehr dieser Monomer-Einheiten zu verwenden, wie z.B. in der WO 02/077060 beschrieben. Bevorzugte Einheiten für das Polymergrundgerüst sind insbesondere Spirobifluoren-, Indenofluoren-, Phenanthren- und Dihydrophenanthren-Derivate.

Besonders bevorzugte Einheiten der Gruppe 1 sind zweibindige Einheiten gemäß den folgenden Formeln, worin die gestrichelten Linien die Verknüpfungen zu den benachbarten Einheiten bedeuten: 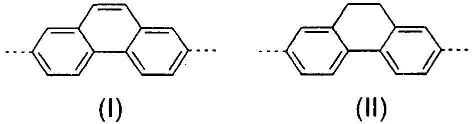 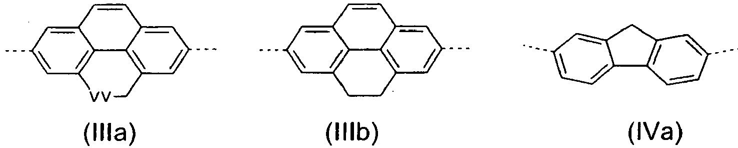 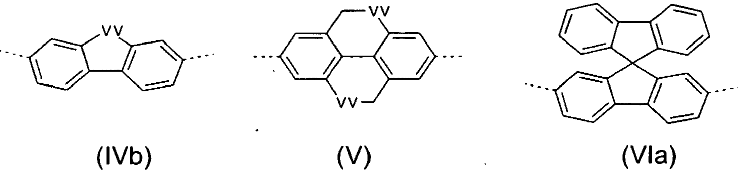 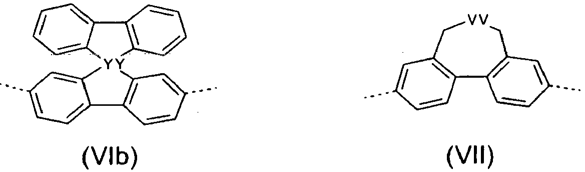 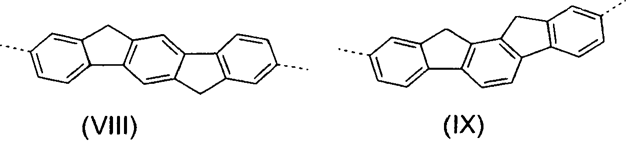 worin die einzelnen Reste folgende Bedeutung besitzen:
- YY: ist Si oder Ge,
- VV: ist O, S oder Se,
und wobei die verschiedenen Formeln an den freien Positionen auch zusätzlich durch einen oder mehrere Substituenten R² substituiert sein können und R² folgendes bedeuten:
R² ist bei jedem Auftreten gleich oder verschieden H, eine geradkettige, verzweigte oder cyclische Alkyl- oder Alkoxykette mit 1 bis 22 C-Atomen, in der auch ein oder mehrere nicht benachbarte C-Atome durch O, S, CO, O-CO, CO-O oder O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein der mehrere C-Atome durch O, S oder N ersetzt sein können, welche auch durch ein oder mehrere nicht-aromatische Reste R² substituiert sein können, oder F, CN, N(R³)² oder B(R³)₂; und
R³ ist bei jedem Auftreten gleich oder verschieden H, ein geradkettige, verzweigte oder cyclische Alkylkette mit 1 bis 22 C-Atom n, in der auch ein oder mehrere nicht benachbarte C-Atome durch O, S, CO, O-CO, CO-O oder O-CO-O ersetzt sein können, wobei auch ein oder mehrere H-Atome durch Fluor ersetzt sein können, oder eine optional substituierte Arylgruppe mit 5 bis 40 C-Atomen, bei der auch ein oder mehrere C-Atome durch O, S oder N ersetzt sein können.

### Gruppe 2 - Struktureinheiten, welche die Lochinjektions- und/oder -transporteigenschaften der Polymere erhöhen:

Dies sind im Allgemeinen substituierte oder unsubstituierte Triarylamine, Benzidine, Tetraarylen-para-phenylendiamine, Phenothiazine, Phenoxazine, Dihydrophenazine, Thianthrene, Dibenzo-*p*-dioxine, Phenoxathiine, Carbazole, Azulene, Thiophene, Pyrrole und Furane. Bevorzugte Einheiten der Gruppe 2 sind zweibindige Einheiten gemäß den folgenden Formeln, worin die gestrichelten Linien die Verknüpfungen zu den benachbarten Einheiten bedeuten: 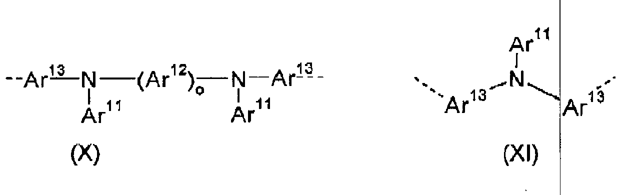 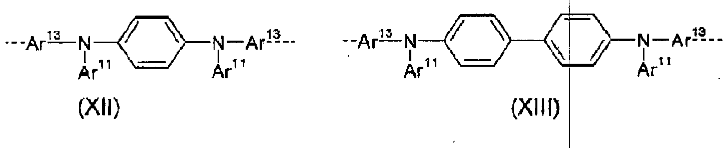 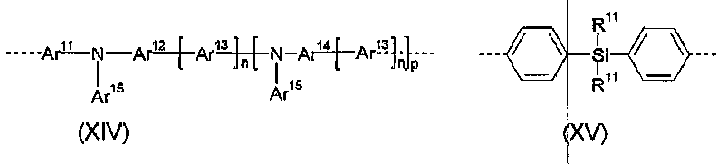 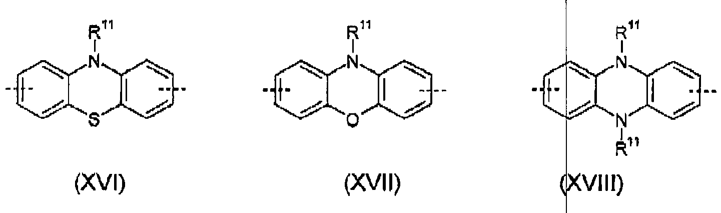 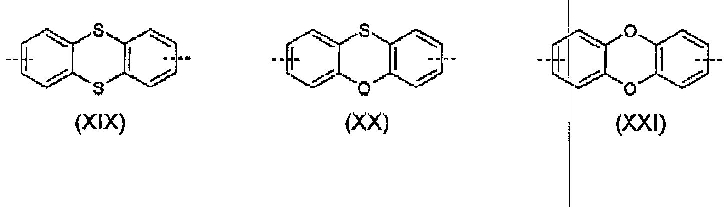 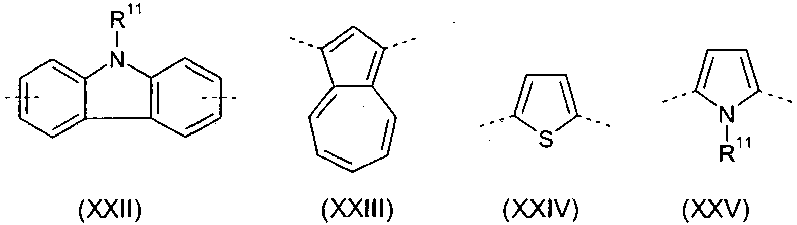 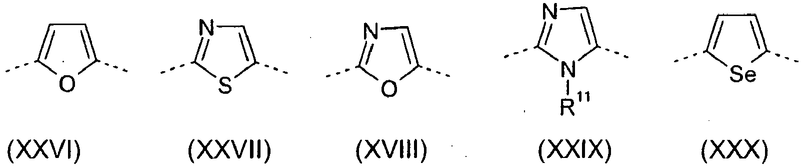 wobei R¹¹ eine der oben für R² angegebenen Bedeutungen besitzt, die verschiedenen Formeln an den freien Positionen auch zusätzlich durch einen oder mehrere Substituenten R¹¹ substituiert sein können und die Symbole und Indices folgendes bedeuten:
n ist gleich oder verschieden bei jedem Auftreten 0, 1 oder 2,
p ist gleich oder verschieden bei jedem Auftreten 0, 1 oder 2, vorzugsweise 0 oder 1,
o ist gleich oder verschieden bei jedem Auftreten 1, 2 oder 3, vorzugsweise 1 oder 2,
Ar¹¹, Ar¹³ sind bei jedem Auftreten gleich oder verschieden ein aromatisches oder heteroaromatisches Ringsystem mit 2 bis 40 C-Atomen, welches durch R¹¹ ein- oder mehrfach substituiert oder auch unsubstituiert sein kann; die möglichen Substituenten R¹¹ können dabei potentiell an jeder freien Position sitzen,
Ar¹² , Ar¹⁴ sind bei jedem Auftreten gleich oder verschieden Ar¹¹, Ar¹³ oder eine substituierte oder unsubstituierte Stilbenylen- bzw. Tolanyleneinheit,
Ar¹⁵ ist gleich oder verschieden bei jedem Auftreten entweder ein System gemäß Ar¹¹ oder ein aromatisches oder heteroaromatisches Ringsystem mit 9 bis 40 aromatischen Atomen (C- oder Heteroatome), welches durch R¹¹ ein- oder mehrfach substituiert oder unsubstituiert sein kann und welches aus mindestens zwei kondensierten Ringen besteht; die möglichen Substituenten R¹¹ können dabei potentiell an jeder freien Position sitzen.

### Gruppe 3 - Struktureinheiten, welche die Elektroneninjektions- und/oder -transporteigenschaften der Polymere erhöhen:

Dies sind im Allgemeinen substituierte oder unsubstituierte Pyridine, Pyrimidine, Pyridazine, Pyrazine, Pyrene, Perylene, Anthracene, Benzanthracene, Oxadiazole, Chinoline, Chinoxaline, Phenazine, Benzimidazole, Ketone, Phosphin-oxide, Sulfoxide und Triazine.

Bevorzugte Einheiten der Gruppe 3 sind zweibindige Einheiten gemaß den folgende n Formeln, worin die gestrichelten Linien die Verknüpfungen zu den benachbarten Einheiten bedeuten: 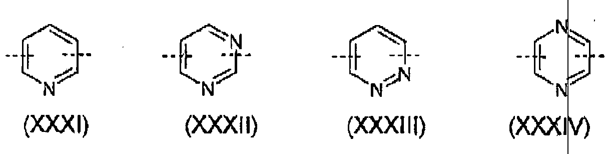 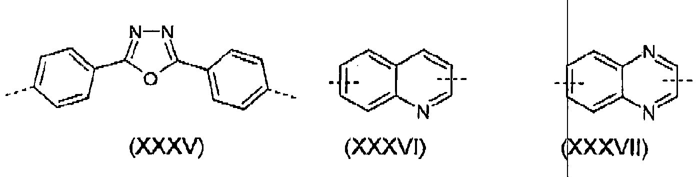 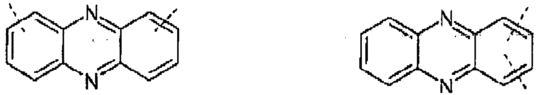 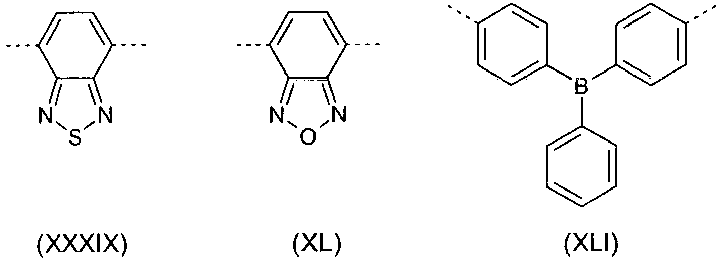 wobei die verschiedenen Formeln an den freien Positionen durch einen oder mehrere Substituenten R¹¹ wie oben definiert substituiert sein können.

### Gruppe 4 - Struktureinheiten, die Kombinationen von Einzeleinheiten der Gruppe 2 und Gruppe 3 aufweisen:

Es ist auch möglich, dass die Polymere Einheiten enthalten, in denen Strukturen, welche die Lochmobilität und welche die Elektronenmobilität erhöhen, direkt aneinander gebunden sind oder beides können. Allerdings verschieben einige dieser Einheiten die Emissionsfarbe ins Gelbe oder Rote. Ihre Verwendung in der erfindungsgemäßen optoelektronischen Vorrichtung zur Erzeugung blauer oder grüner Emission ist deshalb weniger bevorzugt.

Falls solche Einheiten der Gruppe 4 in den Polymeren enthalten sind, sind sie vorzugsweise ausgewählt aus zweibindigen Einheiten gemäß den folgenden Formeln, worin die gestrichelten Linien die Verknüpfungen zu den benachbarten Einheiten bedeuten: 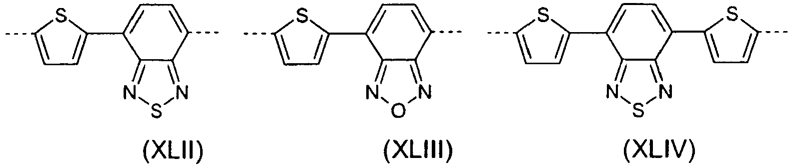 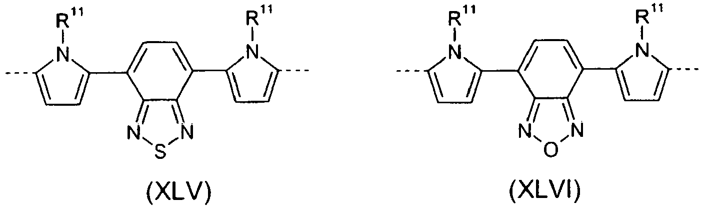 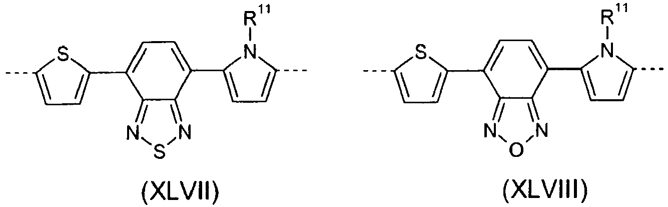 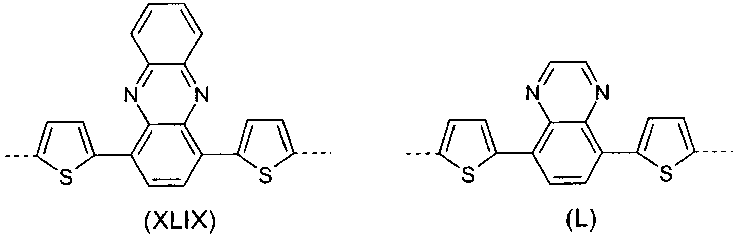 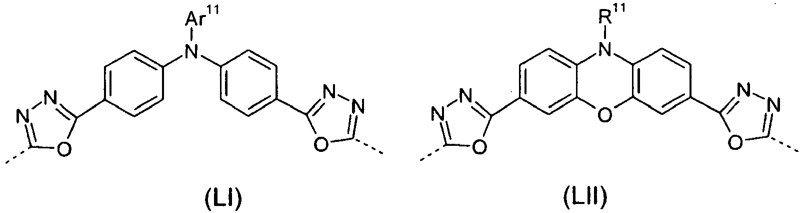 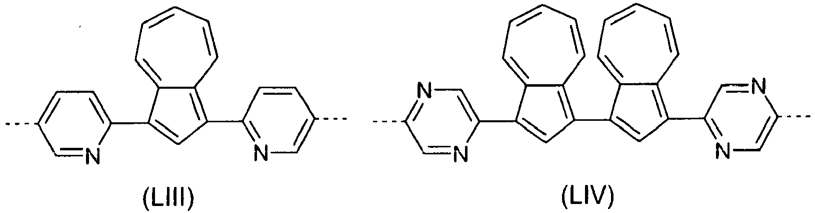 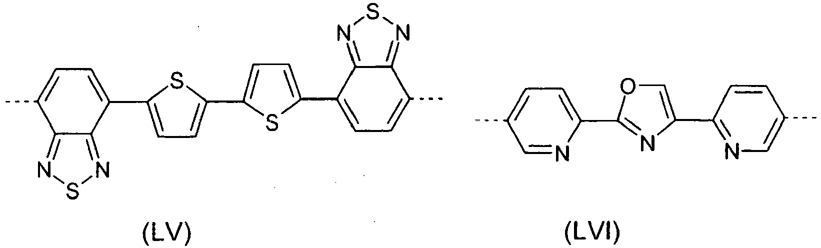 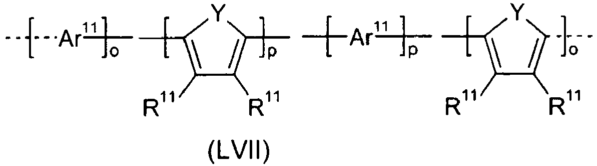 wobei die verschiedenen Formeln an den freien Positionen durch einen oder mehrere Substituenten R¹¹ substituiert sein können, die Symbole R¹¹, Ar¹¹, p und o die oben genannten Bedeutungen besitzen und Y bei jedem Auftreten gleich oder verschieden O, S, Se, N, P, Si oder Ge ist.

### Gruppe 5 - Struktureinheiten, welche die Morphologie und/oder die Emissionsfarbe der resultierenden Polymere beeinflussen:

Dies sind neben den oben genannten Einheiten solche, die mindestens noch eine weitere aromatische oder eine andere konjugierte Struktur aufweisen, welche nicht unter die o. g. Gruppen fällt, d.h. die die Ladungsträgermobilität nur wenig beeinflusst, die keine metallorganischen Komplexe sind oder die keinen Einfluss auf den Singulett-Triplett-Übergang haben. Derartige Strukturelemente können die Morphologie, aber auch die Emissionsfarbe der resultierenden Polymere beeinflussen. Je nach Einheit können sie daher auch als Emitter eingesetzt werden. Bevorzugt sind dabei substituierte oder unsubstituierte aromatische Strukturen mit 6 bis 40 C-Atomen oder auch Tolan-, Stilben- oder Bisstyrylarylenderivate, die jeweils mit einem oder mehreren Resten R¹¹ substituiert sein können. Besonders bevorzugt ist dabei der Einbau von 1,4-Phenylen-, 1,4-Naphthylen-, 1,4- oder 9,10-Anthrylen-, 1,6-, 2,7- oder 4,9-Pyrenylen-, 3,9- oder 3,10- Perylenylen-, 4,4'-Biphenylylen-, 4,4"-Terphenylylen-, 4,4'-Bi-1,1'-naphthylylen-, 4,4'-Tolanylen-, 4,4'-Stilbenylen- oder 4,4"-Bisstyrylarylenderivaten.

Ganz besonders bevorzugt sind substituierte oder unsubstituierte Strukturen gemäß den folgenden Formeln, worin die gestrichelten Linien die Verknüpfungen zu den benachbarten Einheiten bedeuten: 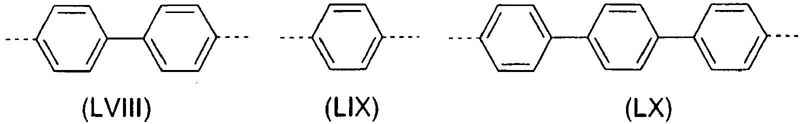 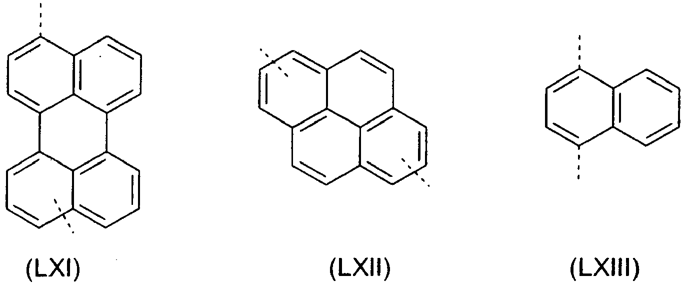 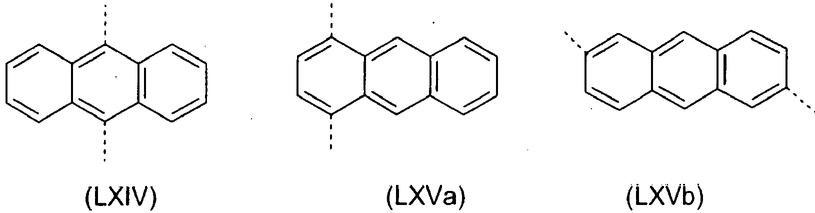 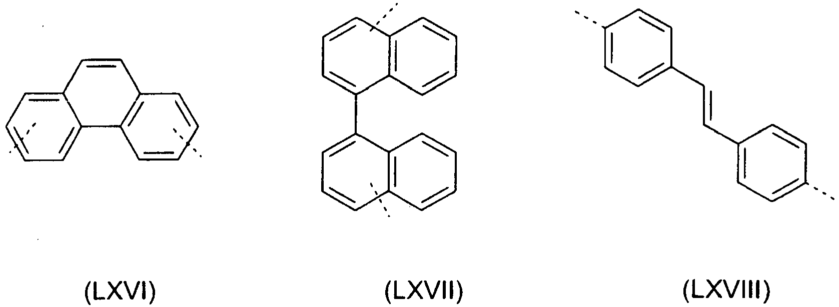 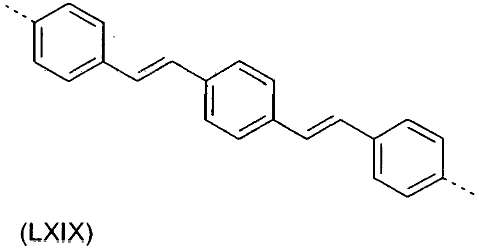 wobei die verschiedenen Formeln an den freien Positionen durch einen oder mehrere Substituenten R¹¹ wie oben definiert substituiert sein können.

### Gruppe 6 - Struktureinheiten, welche die Emissionscharakteristik insoweit verändern, dass Elektrophosphoreszenz statt Elektrofluoreszenz erhalten werden kann:

Dies sind insbesondere solche Einheiten, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Besonders geeignet sind Verbindungen, welche d- oder f-Übergangsmetalle beinhalten, die die o. g. Bedingung erfüllen. Ganz besonders bevorzugt sind hier entsprechende Struktureinheiten, welche Elemente der Gruppe 8 bis 10 (Ru, Os, Rh, Ir, Pd, Pt) enthalten. Als Struktureinheiten für die Polymeren kommen hier z.B. verschiedene Komplexe in Frage, welche z.B. in der WO 02/068435, der WO 02/081488, der EP 1239526 und der WO 04/026886 beschrieben sind. Entsprechende Monomere sind in der WO 02/068435 und der WO 2005/042548 A1 beschrieben.

Bevorzugte Einheiten der Gruppe 6 sind solche der folgenden Formeln, worin die gestrichelten Linien die Verknüpfungen zu den benachbarten Einheiten bedeuten: 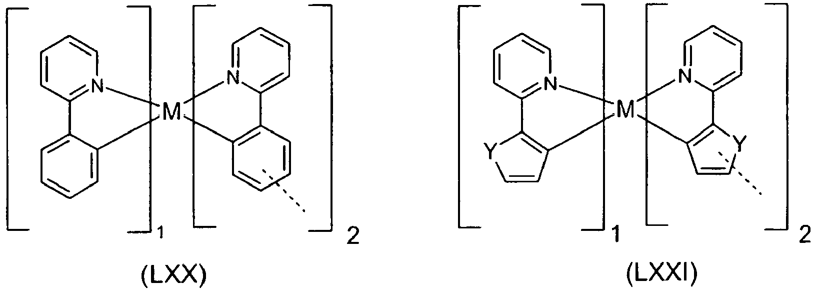 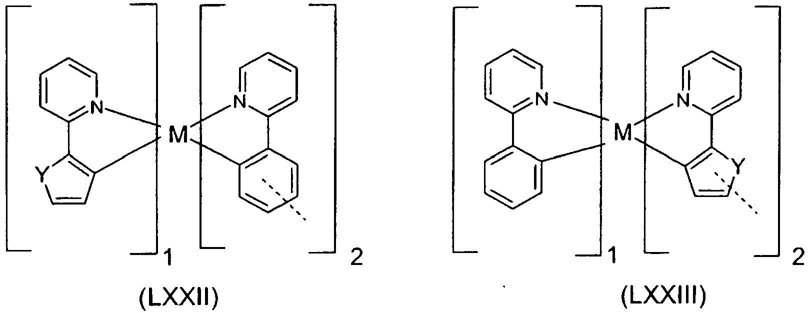 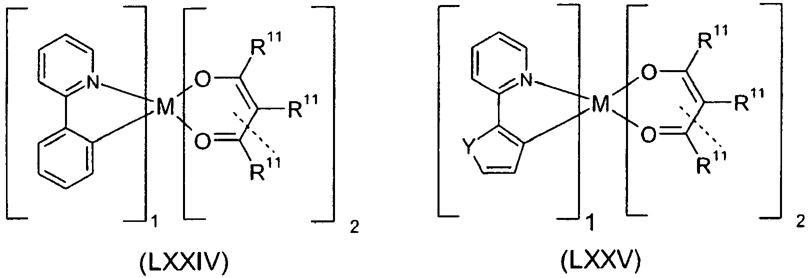 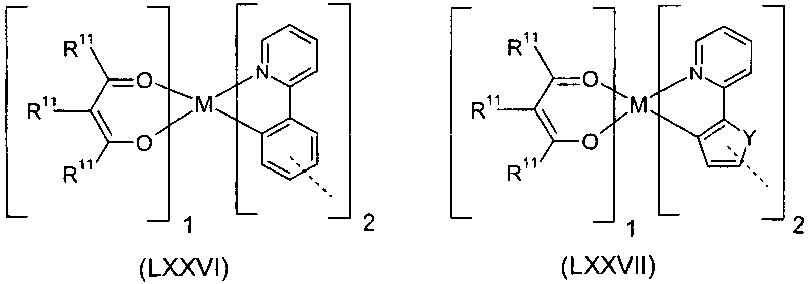 worin M für Rh oder Ir steht, Y die oben angegebene Bedeutung hat, und die verschiedenen Formeln an den freien Positionen durch eine oder mehrere Substituenten R¹¹ wie oben definiert substituiert sein können.

### Gruppe 7 - Struktureinheiten, welche den Übergang vom Singulett- zum Triplettzustand verbessern:

Dies sind insbesondere solche Einheiten, welche den Übergang vom Singulett- zum Triplettzustand verbessern und welche, unterstützend zu den Strukturelementen der Gruppe 6 eingesetzt, die Phosphoreszenzeigenschaften dieser Strukturelemente verbessern. Hierfür kommen insbesondere Carbazol- und überbrückte Carbazoldimereinheiten in Frage, wie z.B. in der WO 04/070772 und der WO 04/113468 beschrieben. Weiterhin kommen hierfür Ketone, Phosphinoxide, Sulfoxide und ähnliche Verbindungen in Frage, wie z.B. in der WO 2005/040302 A1 beschrieben.

Es ist auch möglich, dass gleichzeitig mehr als eine Struktureinheit aus einer der Gruppen 1 bis 7 vorliegt.

Das Polymer kann weiterhin ebenfalls in die Haupt- oder Seitenkette gebundene Metallkomplexe enthalten, die im Allgemeinen aus einem oder mehreren Liganden und einem oder mehreren Metallzentren aufgebaut sind.

Bevorzugt sind Polymere, die zusätzlich noch ein oder mehrere Einheiten ausgewählt aus den Gruppen 1 bis 7 enthalten.

Ebenfalls bevorzugt ist es, wenn die Polymere Einheiten enthalten, die den Ladungstransport oder die Ladungsinjektion verbessern, also Einheiten aus Gruppe 2 und/oder 3; besonders bevorzugt ist ein Anteil von 1 bis 30 mol% dieser Einheiten; ganz besonders bevorzugt ist ein Anteil von 2 bis 10 mol% dieser Einheiten.

Besonders bevorzugt ist es weiterhin, wenn die Polymere Einheiten aus Gruppe 1, Einheiten aus Gruppe 2 und/oder 3 und Einheiten aus Gruppe 5 enthalten.

Die Polymere weisen vorzugsweise 10 bis 10000, besonders bevorzugt 20 bis 5000 und insbesondere 50 bis 2000 Wiederholungseinheiten auf. Davon zu unterscheiden sind die erfindungsgemäßen fluorierten Oligomere, welche 3 bis 9 Wiederholungseinheiten aufweisen. Ansonsten können auch die Oligomere alle oben definierten Wiederholungseinheiten, auch die Emitter, besitzen.

Die nötige Löslichkeit der Polymere wird vor allem durch die Substituenten an den verschiedenen Wiederholungseinheiten gewährleistet.

Die Polymere können linear, verzweigt oder vernetzt sein. Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich in der WO 2005/014688 beschrieben. Diese Schrift ist via Zitat Bestandteil der vorliegenden Anmeldung.

Die Polymere werden in der Regel durch Polymerisation von einer oder mehreren Monomersorten hergestellt. Geeignete Polymerisationsreaktionen sind dem Fachmann bekannt und in der Literatur beschrieben. Besonders geeignete und bevorzugte Polymerisations- und Kupplungsreaktionen, die alle zu C-C-Verknüpfungen führen, sind solche gemäß SUZUKI, YAMAMOTO, STILLE, HECK, NEGISHI, SONOGASHIRA oder HIYAMA.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 2003/048225 und der WO 2004/037887, im Detail beschrieben.

Die C-C-Verknüpfungen sind bevorzugt ausgewählt aus den Gruppen der SUZUKI-Kupplung, der YAMAMOTO-Kupplung und der STILLE-Kupplung.

Zur Synthese der Polymere werden die entsprechenden Monomere benötigt. Die Synthese von Einheiten aus Gruppe 1 bis 7 ist dem Fachmann bekannt und in der Literatur, beispielsweise in der WO 2005/014689, beschrieben. Diese und die darin zitierte Literatur ist via Zitat Bestandteil der vorliegenden Anmeldung.

Zur Erreichung der Teilfluorierung der Polymere können die Monomere mit den oben genannten Gruppen der allgemeine Formel CₓH_{y}F_{z} modifiziert und als Bestandteile der Copolymere einpolymerisiert werden.

Es kann außerdem bevorzugt sein, das Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern oder selber emittieren. Solche Blends sind daher auch Bestandteil der vorliegenden Erfindung.

Gegenstand der Erfindung sind weiterhin Lösungen und Formulierungen aus einem oder mehreren fluorhaltigen Polymeren und/oder fluorhaltigen Blends und/oder fluorierten kleinen Molekülen gemäß der Erfindung (wie oben definiert) in einem oder mehreren Lösungsmitteln. Wie Polymerlösungen oder Lösungen kleiner Moleküle hergestellt werden können, ist dem Fachmann bekannt und z.B. in der WO 02/072714, der WO 03/019694 und der darin zitierten Literatur beschrieben. Die Lösungen und Formulierungen können gegebenenfalls ein oder mehrere Additive enthalten.

Diese Lösungen können verwendet werden, um dünne Polymerschichten herzustellen, zum Beispiel durch Flächenbeschichtungsverfahren (z. B. Spin-coating) oder durch Druckverfahren (z.B. InkJet Printing), insbesondere in dem erfindungsgemäßen Verfahren.

Gegenstand der Erfindung ist auch ein Verfahren zur Herstellung einer optoelektronischen Vorrichtung, umfassend das Erzeugen einer Schicht eines Polymers, enthaltend fluorhaltige Gruppen.

Bevorzugt umfasst das Verfahren die Schritte des
a) Aufbringens einer ersten Schicht auf ein Substrat, und
b) Aufbringens wenigstens einer zweiten Schicht.

Bevorzugt ist die erste Schicht eine teilfluorierte Lochinjektionsschicht, bestehend aus einem teilfluorierten Copolymer, das vor dem Abscheiden durch Copolymerisation mit fluorierten Monomeren oder polymeranaloge Fluorierung herstellt wurde.

In einer bevorzugten Ausführungsform wird als Elektrode Indium-Zinnoxid (ITO) oder Indium-Zinkoxid (IZO) verwendet. Dieses kann mit Hilfe einer CF₄-Plasmabehandlung modifiziert werden, um zusätzlich eine adhäsive Wechselwirkung mir der folgenden fluorierten Schicht zu erzeugen.

Ebenfalls bevorzugt ist die erste Schicht die Emitterschicht selbst, die zuvor durch die Verwendung fluorierter Monomere funktionalisiert und auf die PANI- bzw. PEDOT-Schicht oder eine lochinjizierende Zwischenschicht aufgebracht wird. Darüber können dann elektronentransportierende bzw. lochblockierende Schichten aus anderen oder sogar demselben Lösungsmittel aufgebracht werden.

Als Substrat wird erfindungsgemäß Glas oder eine Polymerfolie verwendet, bevorzugt ist Glas.

In einer weiteren bevorzugten Ausführungsform ist die Elektrode ein leitfähiges Polymer und die fluorhaltigen Gruppen werden vor der Aufbringung der Elektrode auf das Substrat in das leitfähige Polymer eingebracht. Bevorzugt wird als leitfähiges Polymer eines der oben definierten konjugierten Polymere PEDOT oder PANI verwendet, welche bevorzugt mit fluorhaltigen Gruppen versehen sind. Bei einem leitfähigen Polymer erfolgt die Fluorierung durch Methoden nach dem Stand der Technik, beispielsweise indem fluorierte Monomere polymerisiert werden oder indem das fertige Polymer fluoriert wird. Bevorzugt wird als fluorhaltige Gruppen enthaltende Komponente ein teilweise fluoriertes Polymer oder ein Polymer mit fluorierten oder perfluorierten Seitengruppen, ein Oligomer mit fluorierten Gruppen, ein fluoriertes Molekül, oder Kombinationen davon, eingesetzt.

Die zweite Schicht wird bevorzugt durch Beschichtung aus einer das Polymer enthaltenden Lösung, beispielsweise durch Spin-Coating oder Rackeln, aufgebracht. Für die zweite Schicht wird ein teilweise fluoriertes Polymer, ein Polymer mit perfluorierten Seitengruppen, ein Oligomer mit fluorierten Gruppen oder ein fluoriertes Molekül verwendet. Bevorzugt ist ferner, dass die zweite Schicht eine Ladungsinjektions-funktion, eine Emitterfunktion, eine Barrierefunktion oder Kombinationen der genannten Funktionen aufweist. Dazu kann beispielsweise ein oben definiertes konjugiertes Polymer eingesetzt werden, welches die entsprechenden Funktionen aufweist, oder es können entsprechende Oligomere oder Moleküle eingesetzt werden. Ebenfalls können die oben definierten Emitter in dem erfindungsgemäßen Verfahren eingesetzt werden.

Auf die aufgebrachte Schicht können nun eine oder mehrere zusätzliche Schichten aufgebracht werden, ohne dass die fixierte Schicht angelöst wird oder quillt. Die fluorhaltigen Gruppen dieser Schicht verhindern dabei über die starken intermolekularen Wechselwirkungen das Ablösen des aufgebrachten Materials, was in der Wirkung einer Vernetzungsreaktion gleichkommt.

Auf diese Weise können zudem dickere Schichten hergestellt werden, welche beispielsweise als Lochinjektionsschichten oder Elektronen-Sperrschichten fungieren und diese Schichten können bezüglich Farbe und Effektivität optimiert werden. Darüber hinaus kann die Lebensdauer einer derartigen Schicht durch eine verbesserte Elektronensperrfunktion erhöht werden (weniger Tunneleffekte in die darunter liegende Schicht, insbesondere bei PEDOT der Fall).

Nachdem alle zusätzlichen Schichten nacheinander aufgebracht wurden, folgt ferner das Aufbringen einer Kathode nach im Stand der Technik bekannten Methoden. Zuletzt folgt das Aufbringen einer Verkapselung, um die Vorrichtung vor äußeren Einflüssen wie Wasserdampf, Sauerstoff und dergleichen zu schützen.

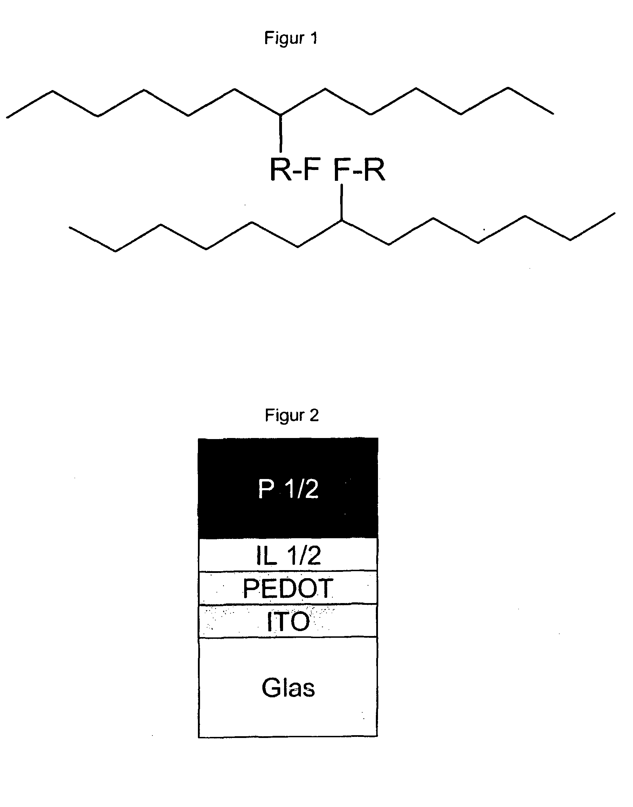

Die Erfindung soll nun anhand eines nicht als beschränkend auf den Umfang der Erfindung zu betrachtenden Ausführungsbeispiels unter Bezugnahme auf die Figuren 1 und 2 näher erläutert werden.

### Ausführungsbeispiele:

### Beispiel 1:

Es wurden durch sukzessives Spincoaten Schichten eines fluorierten Polymers hergestellt, wie in Figur 1 dargestellt. Dazu wurde ein vollflächiges mit ITO beschichtetes Substrat vorgefertigt von Technoprint käuflich erworben. Die mit ITO beschichteten Substrate wurden im Reinraum mit DI Wasser und einem Detergens (Deconex 15 PF) gereinigt und dann durch eine UV/Ozon-Plasmabehandlung aktiviert. Anschließend wurde eine 80 nm dicke PEDOT-Schicht (PEDOT ist ein PolythiophenDerivat (Baytron (jetzt "Clevios") P VAI 4083sp.) von H. C. Starck, Groslar) im Reinraum aufgesponnen und 10 Minuten bei 180°C ausgeheizt, um Restwasser zu entfernen. Danach wurden in einer Glovebox unter ArgonAtmosphäre 20 nm des Polymers IL1 aufgesponnen.

Dieses Polymer ist ein teilfluoriertes Copolymer. Das Polymer wurde durch Suzuki-Polymerisation hergestellt, wie in der WO 03/048225 A2 beschrieben, unter Verwendung der im Folgenden dargestellten Monomere (Prozentangaben = mol%). Aufgrund seines hohen Triphenylamingehaltes ist dieses Polymer als sog. Interlayer in lösungsprozessierten OLEDs geeignet, d.h. es dient als Zwischenschicht zwischen dem Puffer PEDOT/PSSH und den in einem nachfolgenden Schritt abgeschiedenen Polymeren P1 oder P2 und sorgt für effiziente Lochinjektion von PEDOT in diese (oder eine andere) weitere Polymerschicht.

### Polymer IL1:

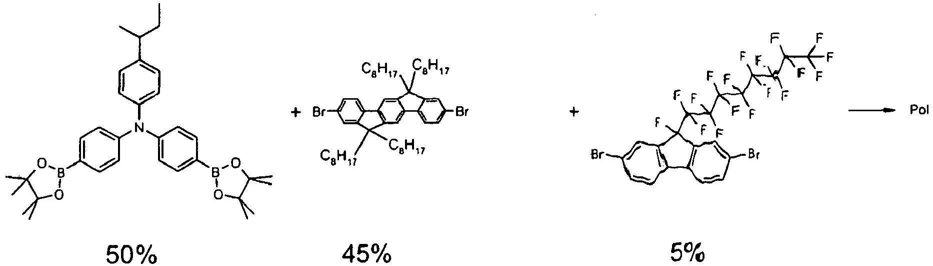

Die benötigte Spinrate für eine Schichtdicke von 20 nm wurde durch das Aufschleudern der Polymere auf Glassubstrate aus einer Lösung mit einer Konzentration von 5 mg/ml bestimmt. Dazu wurde der Film in einer Glovebox unter Devicepräparationsbedingungen aufgeschleudert und 1 Stunde bei 180°C ausgeheizt. Die Schichtdickenmessung erfolgte mit einem Profilometer (Dektak 3ST Surface Profiler von Veeco Instruments), das die Schichtdicke mit Hilfe einer Nadel misst, die über einen mit einem Skalpell im Film angebrachten Schnitt fährt und über eine Kraftmessung dessen Tiefe misst.

Die Spinrate für das Polymer IL1 betrug:
IL1 (5mg/ml in Toluol): 2400 U/min für 20 nm auf Glas

### Vergleichsbeispiel 2:

Es wurden durch sukzessives Spincoaten Schichten hergestellt, analog Beispiel 1.

Jedoch wurde anstelle des teilfluorierten Polymers das entsprechende nicht-fluorierte Copolymer IL2 eingesetzt. Auch dieses Polymer wurde durch Suzuki-Polymerisation hergestellt, wie in der WO 03/048225 A2 beschrieben, unter Verwendung der im Folgenden dargestellten Monomere (Prozentangaben = mol%). Auch dieses Polymer ist aufgrund seines hohen Triphenylamingehaltes als sog. Interlayer in lösungsprozessierten OLEDs geeignet, d.h. es dient als Zwischenschicht zwischen dem Puffer PEDOT/PSSH und den in einem nachfolgenden Schritt abgeschiedenen Polymeren P1 oder P2 und sorgt für effiziente Lochinjektion von PEDOT in diese (oder eine andere) weitere Polymerschicht.

### Polymer IL2:

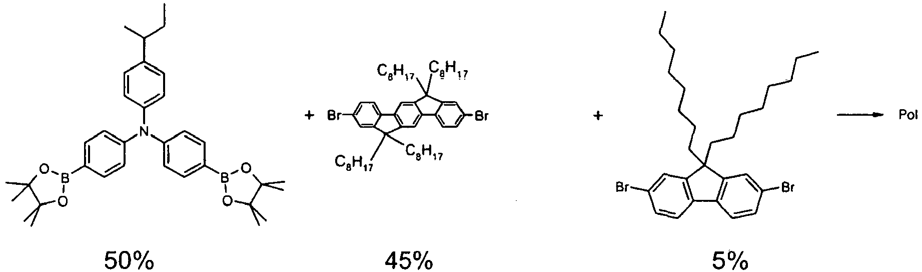

Die benötigte Spinrate für eine Schichtdicke von 20 nm wurde analog Beispiel 1 bestimmt. Sie betrug für das Polymer IL2:
IL2 (5mg/ml in Toluol): 1810 U/min für 20 nm auf Glas

Der Vergleich der Spinraten für Polymer IL1 und IL2 zeigt, dass die kohäsiven Kräfte der Lösung IL1 deutlich höher waren als die von IL2, da die für IL1 benötigte Spinrate deutlich höher war als für IL2.

### Beispiel 3

Da es sich bei den in den Beispielen 1 und 2 eingesetzten Interlayerpolymeren um Polymere handelte, die keine chemisch vernetzbaren Gruppen (z.B. Oxetangruppen) enthielten, sollte der weitere Aufbau einer Schichtstruktur, wie in Figur 2 dargestellt, dazu führen, dass die zunächst aufgebrachte Interlayerschicht zumindest teilweise wieder abgewaschen wird. Um dies für die Polymere IL1 und IL2 zu überprüfen, wurden mit der Spinrate, wie sie für Glas ermittelt wurde, Schichten auf PEDOT hergestellt und wiederum 1 Stunde bei 180°C ausgeheizt. Beide Polymere lieferten (wegen der unterschiedlichen Spinraten) gleiche Schichtdicken von 15 nm.
IL1 (5mg/ml in Toluol), 2400 U/min auf PEDOT: 15 nm
IL2 (5mg/ml in Toluol), 1810 U/min auf PEDOT: 15 nm

Anschließend wurden die Schichten mit Toluol (reines Lösungsmittel) bei 1000 U/min übersponnen. Während sich das teilfluorierte Polymer IL1 wegen der starken Fluor-Fluor-Wechselwirkung wie physikalisch vernetzt verhielt und sich daher nicht wieder lösen ließ, wurden mehr als 50% von IL2 abgewaschen.
15nm IL1 auf PEDOT, übersponnen mit Toluol bei 1000 U/min: 15 nm
15nm IL2 auf PEDOT, übersponnen mit Toluol bei 1000 U/min: 6 nm

Dies zeigt deutlich, dass ein Film eines teilfluorierten Polymers sich aufgrund der kohäsiven Wechselwirkung zwischen den Ketten bei einem weiteren Coatingschritt nicht mehr anlösen bzw. abwaschen lässt, wohingegen ein Film des gleichen nicht-fluorierten Polymers sich sehr wohl anlösen bzw. abwaschen lässt.

### Beispiel 4:

Es galt nun zu überprüfen, ob der Ansatz der physikalischen Vernetzung über eine Fluor-Fluor-Wechselwirkung auch dazu geeignet ist, mehrere Schichten aus dem gleichen Lösungsmittel (Toluol) übereinander abzuscheiden.

Dazu wurden jeweils 80 nm der Polymere P1 und P2 über die vorbereiteten Filme von IL1 und IL2 (aus Toluol, 5 mg/ml, oben genannte Spinraten, 1 Stunde bei 180°C) gecoatet, wie in Figur 2 dargestellt. Die Polymere wurden durch Suzuki-Polymerisation hergestellt, wie in der WO 03/048225 A2 beschrieben, unter Verwendung der im Folgenden dargestellten Monomere (Prozentangaben = mol%).

### Polymer P1:

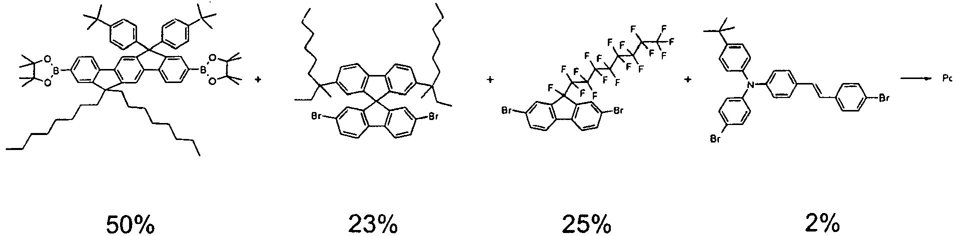

### Polymer P2:

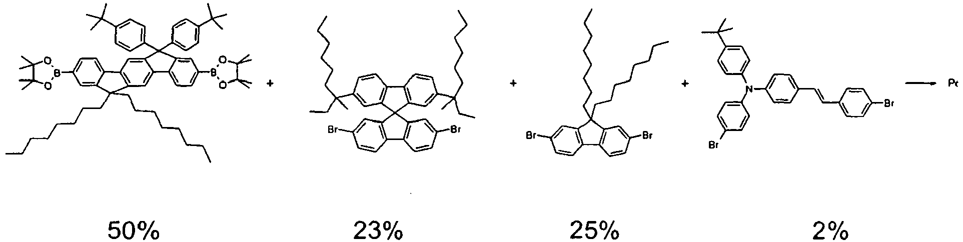

Wegen des konjugierten Poly-para-phenylen-Grundgerüsts und des geringen Prozentsatzes an Triarylaminemitter sind diese Polymere P1 und P2 blau emittierende Polymere. Sie wurden ebenfalls durch Suzuki-Polymerisation hergestellt, wie in der WO 03/048225 A2 beschrieben. Es wurden Lösungen in Toluol in einer Konzentration von 8 mg/ml angesetzt und die Spinraten auf Glas für eine Polymerschichtdicke von 80 nm bestimmt. Danach wurden die Lösungen verwendet, um eine Schicht über die vorbereiteten Filme von IL1 und IL2 zu coaten. Nach dem Coaten wurden die Filme 10 Minuten bei 180°C ausgeheizt.

Es wurden die folgenden Gesamtschichtdicken ermittelt:
IL1 mit P1: 95 nm Schichtdicke (15 nm IL1 plus 80 nm P1)
IL1 mit P2: 95 nm Schichtdicke (15 nm IL1 plus 80 nm P2)
IL2 mit P1: 86 nm Schichtdicke (6 nm IL2 plus 80 nm P1)
IL2 mit P2: 86 nm Schichtdicke (6 nm IL2 plus 80 nm P2)

In den beiden ersten Fällen, in denen die Polymere P1 bzw. P2 auf die Zwischenschicht IL1 (teilfluoriertes Copolymer) aufgebracht wurden, wurden Gesamtschichtdicken erhalten, die der Addition der Zwischenschicht (15 nm) plus der Schichtdicke der Polymerschicht von P1 bzw. P2 (80nm) entsprechen.

In den beiden letzten Fällen, in denen die Polymere P1 bzw. P2 auf die Zwischenschicht IL2 (nicht-fluoriertes Copolymer) aufgebracht wurden, wurden Gesamtschichtdicken erhalten, die geringer waren als die Summe der Dicke der Zwischenschicht (15 nm) und der Dicke der Polymerschicht von P1 bzw. P2 (80nm), d.h. dass beim Aufbringen der Polymerschicht zumindest ein Teil der Zwischenschicht angelöst und abgewaschen worden ist, wie dies auch beim Überspinnen mit dem reinen Lösungsmittel der Fall war.

### Beispiel 5:

Die in Beispiel 4 erhaltenen Schichten wurden wie in Beispiel 3 nochmals mit reinem Toluol bei 1000 U/min übersponnen, um auch hier die physikalische Vernetzung des teilfluorierten Films zu testen.

Es wurden die Gesamtschichtdicken vor der Behandlung mit Toluol und nach der Behandlung mit Toluol ermittelt. Die Ergebnisse sind in der folgenden Tabelle dargestellt:

| Beispiel | Schichtfolge | Vorher | Nachher |
|---|---|---|---|
| 5a | IL1 mit P1 | 95 nm (15 + 80 nm) | 76 nm (15 + 61 nm) |
| 5b | IL1 mit P2 | 95 nm (15 + 80 nm) | 16 nm (15 + 01 nm) |
| 5c | IL2 mit P1 | 86 nm (6 + 80 nm) | 67 nm (06 + 61 nm) |
| 5d | IL2 mit P2 | 86 nm (6 + 80 nm) | 03 nm (03 + 00 nm) |

Wie die Tabelle zeigt, wurde in den Beispielen 5a und 5c nur ein geringer Teil der Polymerschicht abgewaschen, und zwar aufgrund der Fluor-Fluor-Wechselwirkung, die zu einer "physikalischen Vernetzung" führt. Dies wird dadurch nochmals untermauert, dass unabhängig von der darunterliegen Interlayerschicht jeweils die gleiche Menge an fluoriertem Polymer P1 abgetragen wird (je 19 nm).

Demgegenüber wurde in den Beispielen 5b und 5d fast die ganze bzw. die ganze Polymerschicht abgewaschen, aufgrund der fehlenden Fluor-Fluor-Wechselwirkung. In Beispiel 5d wurde zudem zusätzlich noch ein Teil der nicht fluorierten Zwischenschicht abgewaschen.

### Beispiel 6:

Wie in den Beispielen 1 und 2 gezeigt, deuteten die unterschiedlichen Spinraten (bei gleicher Konzentration) auf eine unterschiedlich große Kohäsion der Ketten und eine daraus resultierende unterschiedliche Viskosität der Lösungen hin. Umgekehrt wurden nun die beiden Lösungen bei identischen Spinbedingungen gecoated.

Es ergaben sich die folgenden Schichtdicken:
IL1 (5mg/ml in Toluol): 2400 U/min => 20 nm auf Glas
IL2 (5mg/ml in Toluol): 2400 U/min => 15 nm auf Glas

Wie die Ergebnisse zeigen, wurde im Falle des nicht fluorierten Polymers IL2 deutlich mehr Material weggeschleudert als im Falle des teilfluorierten Polymers IL1, wo die Fluor-Fluor-Wechselwirkung dies verhindert hat.

## Patentansprüche

1. Optoelektronische Vorrichtung umfassend mindestens eine Schicht, **dadurch gekennzeichnet, dass** diese mindestens eine Schicht ein Polymer mit 1 bis 50% Wiederholungseinheiten, bezogen auf die Wiederholungseinheiten des Polymers, mit fluorhaltigen Gruppen sowie weiteren Struktureinheiten ausgewählt aus:
a) Fluoren-, Indenofluoren-, Spirobifluoren-, Phenanthren- und Dihydrophenanthren-Derivaten,
b) substituierten oder unsubstituierten Triarylaminen, Benzidinen, Tetraarylen-para-phenylendiaminen, Phenothiazinen, Phenoxazinen, Dihydrophenazinen, Thianthrenen, Dibenzo-p-dioxinen, Phenoxathiinen, Carbazolen, Azulenen, Thiophenen, Pyrrolen und Furanen, und/oder
c) substituierten oder unsubstituierten Pyridinen, Pyrimidinen, Pyridazinen, Pyrazinen, Pyrenen, Perylenen, Anthracenen, Benzanthracenen, Oxadiazolen, Chinolinen, Chinoxalinen, Phenazinen, Benzimidazolen, Ketonen, Phosphinoxiden, Sulfoxiden und Triazinen, enthält
wobei zumindest zwischen einem Teil der fluorhaltigen Gruppen der Schicht eine kohäsive Fluor-Fluor-Wechselwirkung besteht.

2. Optoelektronische Vorrichtung nach Anspruch 1, **dadurch gekennzeichnet, dass** die Schicht ein Polymer mit Ladungsinjektions- und/oder Ladungstransportfunktion ist.

3. Optoelektronische Vorrichtung nach Anspruch 1 oder 2, **dadurch gekennzeichnet, dass** die Schicht ein Polymer mit Emitterfunktion ist.

4. Optoelektronische Vorrichtung nach einem oder mehreren der Ansprüche 1 bis 3, **dadurch gekennzeichnet, dass** das Polymer ein Blend aus zwei oder mehr Polymeren ist.

5. Optoelektronische Vorrichtung nach einem oder mehreren der Ansprüche 1 bis 4, umfassend wenigstens eine weitere Schicht.

6. Optoelektronische Vorrichtung nach Anspruch 5, **dadurch gekennzeichnet, dass** die weitere Schicht ein Polymer mit Lochinjektionsfunktion, Lochtransportfunktion, Lochblockierfunktion, Emitterfunktion, Elektroneninjektionsfunktion, Elektronenblockierfunktion und/oder Elektronentransportfunktion umfasst.

7. Optoelektronische Vorrichtung nach Anspruch 5 oder 6, **dadurch gekennzeichnet, dass** die weitere Schicht ein Polymer mit fluorhaltigen Gruppen enthält.

8. Optoelektronische Vorrichtung nach Anspruch 6 oder 7, **dadurch gekennzeichnet, dass** das Polymer eine Emitterfunktion aufweist.

9. Optoelektronische Vorrichtung nach Anspruch 6 oder 7, **dadurch gekennzeichnet, dass** die Vorrichtung mehrere Schichten von Polymeren mit Emitterfunktion aufweist.

10. Optoelektronische Vorrichtung nach einem oder mehreren der Ansprüche 2 bis 9, **dadurch gekennzeichnet, dass** die Vorrichtung mehrere Schichten von Polymeren mit Lochtransportfunktion (sog. Lochleiter) umfasst, wobei die Lochleiter energetisch unterschiedliche höchste besetzte Molekülorbitale (HOMO) aufweisen.

11. Optoelektronische Vorrichtung nach einem oder mehreren der Ansprüche 1 bis 10, **dadurch gekennzeichnet, dass** die Vorrichtung mehrere Schichten von Polymeren mit Elektronentransportfunktion (sog. Elektronenleiter) umfasst, wobei die Elektronenleiter energetisch unterschiedliche niedrigste unbesetzte Molekülorbitale (LUMO) aufweisen.

12. Optoelektronische Vorrichtung nach einem oder mehreren der Ansprüche 1 bis 11, **dadurch gekennzeichnet, dass** die Vorrichtung eine Schicht mit kleinen Molekülen oder Oligomeren umfasst.

13. Optoelektronische Vorrichtung nach einem oder mehreren der Ansprüche 1 bis 12, **dadurch gekennzeichnet, dass** zwischen einem Teil der fluorhaltigen Gruppen der ersten Schicht und der wenigstens einen weiteren Schicht eine adhäsive Fluor-Fluor-Wechselwirkung besteht.

14. Verwendung einer optoelektronischen Vorrichtung nach einem oder mehreren der Ansprüche 1 bis 13 als organische oder polymere Leuchtdiode, als organische Solarzelle, als organischer FeldeffektTransistor, als organisches Schaltelement, als organisches Feld-Quench-Element, als organischer optischer Verstärker, als organische Laserdiode, als organischer Photorezeptor oder als organische Photodiode.

15. Verwendung nach Anspruch 14 als OLED in einem Display, in einem farbigen, mehrfarbigen oder vollfarbigen Display, als Beleuchtungselement oder als Backlight in einem Flüssigkristall-Display (LCD).

16. Verwendung nach Anspruch 15, **dadurch gekennzeichnet, dass** die OLED eine weißlichtemittierende OLED ist.

## Claims

1. Opto-electronic device comprising at least one layer, **characterised in that** this at least one layer comprises a polymer containing 1 to 50% of recurring units, based on the recurring units of the polymer, containing fluorine-containing groups and further structural units selected from:
a) fluorene, indenofluorene, spirobifluorene, phenanthrene and dihydrophenanthrene derivatives,
b) substituted or unsubstituted triarylamines, benzidines, tetraarylene-para-phenylenediamines, phenothiazines, phenoxazines, dihydro-phenazines, thianthrenes, dibenzo-p-dioxins, phenoxathiynes, carbazoles, azulenes, thiophenes, pyrroles and furans, and/or
c) substituted or unsubstituted pyridines, pyrimidines, pyridazines, pyrazines, pyrenes, perylenes, anthracenes, benzanthracenes, oxadiazoles, quinolines, quinoxalines, phenazines, benzimidazoles, ketones, phosphine oxides, sulfoxides and triazines,
where a cohesive fluorine-fluorine interaction exists at least between some of the fluorine-containing groups of the layer.

2. Opto-electronic device according to Claim 1, **characterised in that** the layer comprises a polymer having a charge-injection and/or charge-transport function.

3. Opto-electronic device according to Claim 1 or 2, **characterised in that** the layer comprises a polymer having an emitter function.

4. Opto-electronic device according to one or more of Claims 1 to 3, **characterised in that** the polymer is a blend of two or more polymers.

5. Opto-electronic device according to one or more of Claims 1 to 4, comprising at least one further layer.

6. Opto-electronic device according to Claim 5, **characterised in that** the further layer comprises a polymer having a hole-injection function, hole-transport function, hole-blocking function, emitter function, electron-injection function, electron-blocking function and/or electron-transport function.

7. Opto-electronic device according to Claim 5 or 6, **characterised in that** the further layer comprises a polymer containing fluorine-containing groups.

8. Opto-electronic device according to Claim 6 or 7, **characterised in that** the polymer has an emitter function.

9. Opto-electronic device according to Claim 6 or 7, **characterised in that** the device comprises a plurality of layers of polymers having an emitter function.

10. Opto-electronic device according to one or more of Claims 2 to 9, **characterised in that** the device comprises a plurality of layers of polymers having a hole-transport function (so-called hole conductors), where the hole conductors have energetically different highest occupied molecular orbitals (HOMO).

11. Opto-electronic device according to one or more of Claims 1 to 10, **characterised in that** the device comprises a plurality of layers of polymers having an electron-transport function (so-called electron conductors), where the electron conductors have energetically different lowest unoccupied molecular orbitals (LUMO).

12. Opto-electronic device according to one or more of Claims 1 to 11, **characterised in that** the device comprises a layer comprising small molecules or oligomers.

13. Opto-electronic device according to one or more of Claims 1 to 12, **characterised in that** an adhesive fluorine-fluorine interaction exists between some of the fluorine-containing groups of the first layer and the at least one further layer.

14. Use of an opto-electronic device according to one or more of Claims 1 to 13 as organic or polymeric light-emitting diode, as organic solar cell, as organic field-effect transistor, as organic integrated circuit, as organic field-quench element, as organic optical amplifier, as organic laser diode, as organic photoreceptor or as organic photodiode.

15. Use according to Claim 14 as OLED in a display, in a coloured, multicoloured or full-colour display, as lighting element or as backlight in a liquid-crystal display (LCD).

16. Use according to Claim 15, **characterised in that** the OLED is a white-light-emitting OLED.

## Revendications

1. Dispositif opto-électronique comprenant au moins une couche, **caractérisé en ce que** cette au moins une couche comprend un polymère contenant de 1 à 50% d'unités récurrentes, sur la base des unités récurrentes du polymère, contenant des groupes contenant du fluor et d'autres unités structurelles choisies parmi :
a) des dérivés de fluorène, d'indénofluorène, de spirobifluorène, de phénanthrène et de dihydrophénanthrène,
b) des triarylamines, des benzidines, des tétraarylène-para-phényl-énédiamines, des phénothiazines, des phénoxazines, des dihydro-phénazines, des thianthrènes, des dibenzo-p-dioxines, des phénoxa-thiynes, des carbazoles, des azulènes, des thiophènes, des pyrroles et des furanes substitués ou non substitués, et/ou
c) des pyridines, des pyrimidines, des pyridazines, des pyrazines, des pyrènes, des pérylènes, des anthracènes, des benzanthracènes, des oxadiazoles, des quinolines, des quinoxalines, des phénazines, des benzimidazoles, des cétones, des oxydes de phosphine, des sulfoxydes et des triazines substitués ou non substitués,
où une interaction de cohésion fluor-fluor existe au moins entre certains des groupes contenant du fluor de la couche.

2. Dispositif opto-électronique selon la revendication 1, **caractérisé en ce que** la couche comprend un polymère présentant une fonction d'injection de charges et/ou de transport de charges.

3. Dispositif opto-électronique selon la revendication 1 ou 2, **caractérisé en ce que** la couche comprend un polymère présentant une fonction d'émetteur.

4. Dispositif opto-électronique selon une ou plusieurs des revendications 1 à 3, **caractérisé en ce que** le polymère est un mélange de deux polymères ou plus.

5. Dispositif opto-électronique selon une ou plusieurs des revendications 1 à 4, comprenant au moins une autre couche.

6. Dispositif opto-électronique selon la revendication 5, **caractérisé en ce que** l'autre couche comprend un polymère présentant une fonction d'injection de trous, une fonction de transport de trous, une fonction de blocage de trous, une fonction d'émetteur, une fonction d'injection d'électrons, une fonction de blocage d'électrons et/ou une fonction de transport d'électrons.

7. Dispositif opto-électronique selon la revendication 5 ou 6, **caractérisé en ce que** l'autre couche comprend un polymère contenant des groupes contenant du fluor.

8. Dispositif opto-électronique selon la revendication 6 ou 7, **caractérisé en ce que** le polymère présente une fonction d'émetteur.

9. Dispositif opto-électronique selon la revendication 6 ou 7, **caractérisé en ce que** le dispositif comprend une pluralité de couches de polymères présentant une fonction d'émetteur.

10. Dispositif opto-électronique selon une ou plusieurs des revendications 2 à 9, **caractérisé en ce que** le dispositif comprend une pluralité de couches de polymères présentant une fonction de transport de trous (ce que l'on appelle des conducteurs de trous), où les conducteurs de trous présentent des orbites moléculaires occupées les plus hautes (HOMO) énergétiquement différentes.

11. Dispositif opto-électronique selon une ou plusieurs des revendications 1 à 10, **caractérisé en ce que** le dispositif comprend une pluralité de couches de polymères présentant une fonction de transport d'électrons (ce que l'on appelle des conducteurs d'électrons), où les conducteurs d'électrons présentent des orbites moléculaires non occupées les plus basses (LUMO) énergétiquement différentes.

12. Dispositif opto-électronique selon une ou plusieurs des revendications 1 à 11, **caractérisé en ce que** le dispositif comprend une couche comprenant des petites molécules ou oligomères.

13. Dispositif opto-électronique selon une ou plusieurs des revendications 1 à 12, **caractérisé en ce qu'**une interaction adhésive fluor-fluor existe entre certains des groupes contenant du fluor de la première couche et de l'au moins une autre couche.

14. Utilisation d'un dispositif opto-électronique selon une ou plusieurs des revendications 1 à 13 en tant que diode émettrice de lumière organique ou polymérique, en tant que cellule solaire organique, en tant que transistor à effet de champ organique, en tant que circuit intégré organique, en tant qu'élément à extinction de champ organique, en tant qu'amplificateur optique organique, en tant que diode laser organique, en tant que photorécepteur organique ou en tant que photodiode organique.

15. Utilisation selon la revendication 14 en tant qu'OLED dans un affichage, dans un affichage couleur, dans un affichage multicouleur ou pleine couleur, en tant qu'élément d'éclairage ou en tant que lumière arrière dans un affichage à cristaux liquides (LCD).

16. Utilisation selon la revendication 15, **caractérisée en ce que** l'OLED est une OLED émettrice de lumière blanche.
